# EUROPEAN PATENT APPLICATION

(11) **EP 4 197 970 A1**
(43) Date of publication of application: **21.06.2023**
(21) Application number: 21858394.6
(22) Date of filing: 20.08.2021
(51) Int. Cl.: C01B 32/194, B82Y 40/00, H01J 37/20

(54) **GRAPHENE GRID, METHOD FOR PRODUCING GRAPHENE GRID, AND METHOD FOR ANALYZING STRUCTURE OF STRUCTURE ANALYSIS TARGET SUBSTANCE**

(30) Priority: 20.08.2020 JP 2020139703
(71) Applicant: OSAKA UNIVERSITY, Suita-shi Osaka 565-0871 (JP)
(72) Inventor: INOUE Tsuyoshi, Suita-shi, Osaka 565-0871 (JP); ASAHARA Haruyasu, Suita-shi, Osaka 565-0871 (JP); OHKUBO Kei, Suita-shi, Osaka 565-0871 (JP); NAMBA Keiichi, Suita-shi, Osaka 565-0871 (JP); KATO Takayuki, Suita-shi, Osaka 565-0871 (JP); MAKINO Fumiaki, Suita-shi, Osaka 565-0871 (JP); FUJITA Junso, Suita-shi, Osaka 565-0871 (JP); KUMANO Shota, Suita-shi, Osaka 565-0871 (JP)
(74) Representative: J A Kemp LLP
(86) International application number: PCT/JP2021/030519
(87) International publication number: WO 2022/039251

(57) **Abstract**

The present invention provides a graphene grid that can suppress or prevent uneven distribution, uneven orientation, and the like of a structural analysis target substance, and can capture the structural analysis target substance with high efficiency and analyze the structural analysis target substance with high resolution, in a structural analysis by cryo-electron microscopy. A graphene grid of the present invention has a graphene surface into which a functional group is introduced.

## Description

### TECHNICAL FIELD

The present invention relates to a graphene grid, a method for producing a graphene grid, and a method for analyzing a structural analysis target substance.

### BACKGROUND ART

Cryo-electron microscopy is used for a structural analysis of substances such as proteins (Patent Literature 1, etc.).

For the structural analysis of a structural analysis target substance (e.g., a protein) to be analyzed by cryo-electron microscopy, a carbon grid to which a support film made of graphene or amorphous carbon is attached is used to capture the structural analysis target substance.

### Citation List

### Patent Literature

Patent Literature 1: JP 2005-250721 A

### SUMMARY OF INVENTION

### Technical Problem

However, when a structural analysis target substance such as a protein is captured by a carbon grid, uneven distribution (localization), uneven orientation, and the like of the structural analysis target substance may occur on the carbon grid or a sufficient number of structural analysis target substances may not be captured, which may hinder the structural analysis.

With the foregoing in mind, it is an object of the present invention to provide a graphene grid, a method for producing a graphene grid, and a structural analysis target substance that can suppress or prevent uneven distribution, uneven orientation, and the like of a structural analysis target substance, and can capture the structural analysis target substance with high efficiency and analyze the structural analysis target substance with high resolution, in a structural analysis by cryo-electron microscopy.

### Solution to Problem

In order to achieve the above object, the present invention provides a graphene grid having a graphene surface into which a functional group is introduced.

The present invention also provides a method for producing a graphene grid (hereinafter, it may simply be referred to as a "production method of the present invention"), including the steps of: treating a surface by reacting a graphene surface with a halogen oxide radical to modify the graphene surface (hereinafter, also referred to as "surface-treating"); and introducing a functional group into a modified graphene surface (hereinafter, also referred to as "functional group-introducing").

The present invention also provides a method for analyzing a structural analysis target substance using cryo-electron microscopy, including the steps of: preparing a grid for structural analysis; and analyzing a structural analysis target substance, wherein in the preparing a grid for structural analysis, the structural analysis target substance is bonded to the graphene grid according to the present invention or the graphene grid produced by the method according to the present invention, or a grid for cryo-electron microscopy being the graphene grid according to the present invention to which a structural analysis target substance to be analyzed by cryo-electron microscopy is bonded or a grid for cryo-electron microscopy produced by the method for producing a grid for cryo-electron microscopy, including the step of: binding a structural analysis target substance to be analyzed by cryo-electron microscopy to the graphene grid produced by the method according to the present invention is prepared, and in the analyzing a structural analysis target substance, the structural analysis target substance bonded to the graphene grid is analyzed by cryo-electron microscopy.

### Advantageous Effects of Invention

The present invention can provide a graphene grid, a method for producing a graphene grid, and a structural analysis target substance that can suppress or prevent uneven distribution, uneven orientation, and the like of a structural analysis target substance, and can capture the structural analysis target substance with high efficiency and analyze the structural analysis target substance with high resolution, in a structural analysis by cryo-electron microscopy.

### BRIEF DESCRIPTION OF DRAWINGS

[FIG. 1] FIG. 1 is a diagram schematically showing an example of an apparatus for performing the treating a surface using a reaction in a gas phase.
[FIG. 2] FIG. 2 is a graph showing the XPS measurement results of graphene before and after the surface-treating (oxidation reaction) in Reference Examples.
[FIG. 3] FIG. 3 is a graph showing the fluorescence intensity measurement results of graphene to which rhodamine B is bonded in Reference Examples.
[FIG. 4] FIG. 4 shows a schematic view of an apparatus in which the surface-treating is performed using a reaction in a gas phase in Reference Examples, and shows a diagram showing a contact angle of water on a graphene surface before and after the surface-treating.

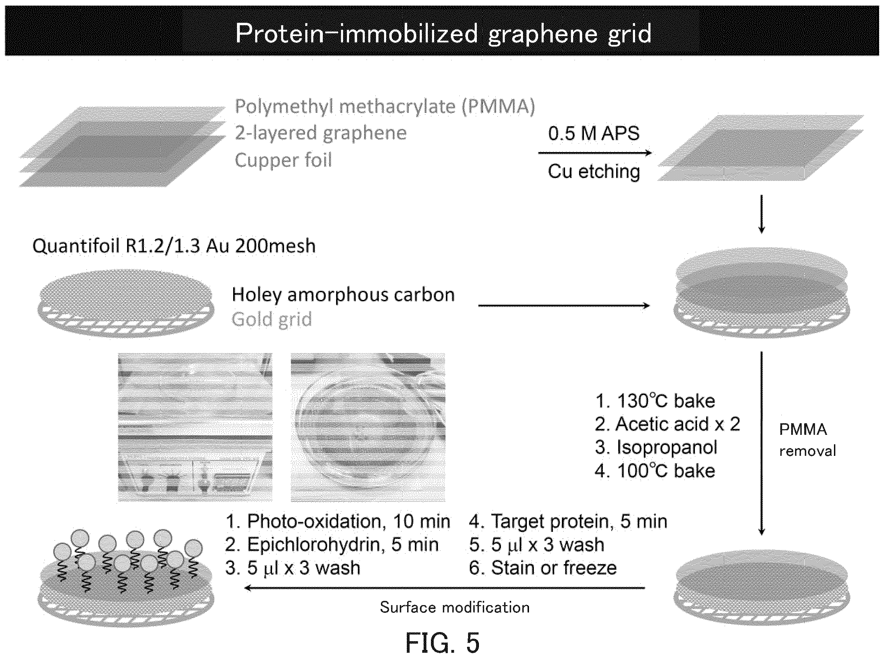

[FIG. 5] FIG. 5 is a scheme showing an outline of the surface-modifying and functional group-introducing of a graphene grid in Examples.
[FIG. 6] FIG. 6 shows a scheme showing an outline of the surface-modifying, functional group-introducing, and β-galactosidase-binding (structural analysis target substance-binding) of a graphene grid, and shows photographs of a graphene grid surface to which β-galactosidase is bonded, observed by a negative staining method in Examples.
[FIG. 7] FIG. 7 shows photographs of the surface of a grid for cryo-electron microscopy with the graphene grid surface to which β-galactosidase is bonded produced in Examples, observed with cryo-electron microscopy.
[FIG. 8] FIG. 8 shows the structural analysis data of the β-galactosidase bonded to the surface of a grid for cryo-electron microscopy, analyzed using cryo-electron microscopy in Examples.
[FIG. 9] FIG. 9 shows the structural analysis data of the β-galactosidase bonded to the surface of a grid for cryo-electron microscopy, analyzed using cryo-electron microscopy in Examples.
[FIG. 10] FIG. 10 shows the structural analysis data of the β-galactosidase bonded to the surface of a grid for cryo-electron microscopy, analyzed using cryo-electron microscopy in Examples.
[FIG. 11] FIG. 11 shows photographs of the graphene grid surface to which GroEL is bonded, observed by a negative staining method in Examples.
[FIG. 12] FIG. 12 shows the structural analysis data of the GroEL bonded to the surface of a grid for cryo-electron microscopy using cryo-electron microscopy in Examples.
[FIG. 13] FIG. 13 shows the structural analysis data of the GroEL bonded to the surface of a grid for cryo-electron microscopy, analyzed using cryo-electron microscopy in Examples.
[FIG. 14] FIG. 14 shows the structural analysis data of the GroEL bonded to the surface of a grid for cryo-electron microscopy, analyzed using cryo-electron microscopy in Examples.
[FIG. 15] FIG. 15 shows the structural analysis data of the GroEL bonded to the surface of a grid for cryo-electron microscopy, analyzed using cryo-electron microscopy in Examples.
[FIG. 16] FIG. 16 shows the structural analysis data of the GroEL bonded to the surface of a grid for cryo-electron microscopy, analyzed using a cryo-electron microscopy in Examples.
[FIG. 17] FIG. 17 is a table summarizing the results of the structural analysis of the β-galactosidase or GroEL, analyzed using cryo-electron microscopy in Examples.
[FIG. 18] FIG. 18 shows the structural analysis data of the V1-ATPase bonded to the surface of a grid for cryo-electron microscopy, analyzed using cryo-electron microscopy in Examples.
[FIG. 19] FIG. 19 shows the structural analysis data of the GroEL bonded to the surface of a grid for cryo-electron microscopy, analyzed using cryo-electron microscopy in Examples.
[FIG. 20] FIG. 20 shows the structural analysis data of the V1-ATPase bonded to the surface of a grid for cryo-electron microscopy, analyzed using cryo-electron microscopy in Examples.
[FIG. 21] FIG. 21 is a diagram showing an example of the measurement results by AFM before and after the surface-treating (oxidation) of graphene.
[FIG. 22] FIG. 22 is a diagram showing an example of the functional group-introducing in Examples.
[FIG. 23] FIG. 23 is a diagram schematically showing an example of the surface-treating using a liquid reaction system.
[FIG. 24] FIG. 24 is a photograph of a graphene grid having a graphene grid surface to which β-galactosidase is bonded produced in Examples, observed by a negative staining method.
[FIG. 25] FIG. 25 is a photograph of the graphene grid surface to which GroEL is bonded, observed by a negative staining method in Examples.

### DESCRIPTION OF EMBODIMENTS

The present invention will be described below in more detail with reference to illustrative examples. The present invention, however, is not limited by the following description.

The graphene grid of the present invention may have, for example, a graphene surface into which at least one substituent selected from the group consisting of a hydroxy group, a carboxy group, and an aldehyde group is introduced, and the functional group is introduced by the reaction of the substituent.

In the graphene grid of the present invention, for example, the functional group may be at least one selected from the group consisting of a hydroxy group, a carboxy group, an aldehyde group (formyl group), a carbonyl group, an ether bond, an ester bond, an amino group, an imino group, a sulfonyl group, a sulfonyloxy group, and a fluoroalkyl group.

In the graphene grid of the present invention, for example, the functional group may be an ether bond.

In the graphene grid of the present invention, for example, the functional group may be an epoxy group.

The graphene grid of the present invention may be, for example, a grid for cryo-electron microscopy being the graphene grid according to the present invention to which a structural analysis target substance to be analyzed by cryo-electron microscopy is bonded.

The grid for cryo-electron microscopy of the present invention may be a graphene grid to which a structural analysis target substance to be analyzed by cryo-electron microscopy is bonded, or may be a graphene grid to which a structural analysis target substance to be analyzed by cryo-electron microscopy is not bonded.

In the method for producing a graphene grid according to the present invention (the production method of the present invention), for example, in the functional group-introducing, at least one functional group selected from the group consisting of a hydroxy group, a carboxy group, an aldehyde group (formyl group), a carbonyl group, an ether bond, an ester bond, an amino group, an imino group, a sulfonyl group, a sulfonyloxy group, and a fluoroalkyl group is introduced as the functional group.

In the production method of the present invention, for example, in the functional group-introducing, an ether bond is introduced as the functional group.

In the production method of the present invention, for example, in the functional group-introducing, an epoxy group is introduced as the functional group.

In the production method of the present invention, for example, the halogen oxide radical is a chlorine dioxide radical.

In the production method of the present invention, for example, the substance obtained by the surface-treating by oxidizing the graphene surface to be modified may be a substance with the oxidized graphene surface.

In the production method of the present invention, for example, in the surface-treating, a reaction system may be irradiated with light or a reaction system may not be irradiated with light.

In the production method of the present invention, for example, the reaction system in the surface-treating may be a gas reaction system or a liquid reaction system.

The production method of the present invention may be, for example, a method for producing a grid for cryo-electron microscopy including the step of: binding a structural analysis target substance to be analyzed by cryo-electron microscopy to the graphene grid produced by the method according to the present invention.

The grid for cryo-electron microscopy produced by the production method of the present invention may be a graphene grid to which a structural analysis target substance to be analyzed by cryo-electron microscopy is bonded, or may be a graphene grid to which a structural analysis target substance to be analyzed by cryo-electron microscopy is not bonded.

In the method for analyzing a structural analysis target substance according to the present invention, for example, the structural analysis target substance may be an organic substance.

In the method for analyzing a structural analysis target substance according to the present invention, for example, the organic substance may be a protein.

The graphene grid of the present invention may be, for example, a grid for instrumental analysis.

The graphene grid of the present invention may be, for example, a grid for electron microscopy.

The graphene grid of the present invention may be, for example, a grid for cryo-electron microscopy.

Further, the use of the graphene grid of the present invention is not limited to a grid for instrumental analysis, a grid for electron microscopy, and a grid for cryo-electron microscopy, and can be used, for example, in applications such as a bioreactor, a sensor (e.g., a biosensor such as an enzyme sensor), a microreactor, and the like, and can also be used in detection reagents when an antibody or various proteins are linked to beads or the like, affinity column chromatography, and the like.

The grid for cryo-electron microscopy of the present invention can be used in a structural analysis method for a structural analysis target substance using cryo-electron microscopy. The specific usage of the grid for cryo-electron microscopy is not particularly limited, and may be, for example, the same as that of a general grid for cryo-electron microscopy. The structural analysis target substance is not particularly limited and may be, for example, at least one selected from the group consisting of a protein, an antibody, a nucleic acid, a virus, a ribosome, a mitochondrion, an ion channel, an enzyme, and an enzyme complex. Examples of the protein to be the structural analysis target substance include, but are not limited to, enzymes, chaperonin proteins, iron storage proteins, antibody-antigen complexes, and virusderived surface proteins. Examples of the enzyme include, but are not limited to, β-galactosidase and V1-ATPase. The chaperonin protein is not particularly limited, and may be, for example, GroEL. The iron storage protein is not particularly limited, and may be, for example, ferritin. The structural analysis target substance may be, for example, a biological substance (a substance derived from a living body or a substance identical thereto), but is not limited thereto and may be selected freely.

In the present invention, the graphene surface can be modified by the surface-treating. Herein, the surface-treating may also be referred to as a "modification treatment" or a "modification method". When oxidizing the graphene by the surface-treating, it can be said that the surface-treating is a method for oxidizing the graphene.

In the present invention, the salt discussed below is not particularly limited, and may be, for example, an acid addition salt or a base addition salt. An acid that forms the acid addition salt may be either an inorganic acid or an organic acid, and a base that forms the base addition salt may be either an inorganic base or an organic base. The inorganic acid is not particularly limited, and examples thereof include sulfuric acid, phosphoric acid, hydrofluoric acid, hydrochloric acid, hydrobromic acid, hydroiodic acid, hypofluorous acid, hypochlorous acid, hypobromous acid, hypoiodous acid, fluorous acid, chlorous acid, bromous acid, iodous acid, fluorine acid, chloric acid, bromic acid, iodic acid, perfluoric acid, perchloric acid, perbromic acid, and periodic acid. The organic acid also is not particularly limited, and examples thereof include p-toluenesulfonic acid, methanesulfonic acid, oxalic acid, p-bromobenzenesulfonic acid, carbonic acid, succinic acid, citric acid, benzoic acid, and acetic acid. The inorganic base is not particularly limited, and examples thereof include ammonium hydroxides, alkali metal hydroxides, alkaline-earth metal hydroxides, carbonates, and hydrogencarbonates. More specifically, the inorganic base may be, for example, sodium hydroxide, potassium hydroxide, potassium carbonate, sodium carbonate, sodium hydrogencarbonate, potassium hydrogencarbonate, calcium hydroxide, or calcium carbonate. The organic base also is not particularly limited, and examples thereof include ethanolamine, triethylamine, and tris(hydroxymethyl)aminomethane.

An embodiment of the present invention will be described below in more detail with reference to illustrative examples. The present invention, however, is by no means limited thereby.

### [1. Surface-treating (Method for Producing Substance with Modified Graphene Surface)]

As described above, the method for producing a graphene grid according to the present invention (the production method of the present invention) includes the steps of: treating a surface by reacting the graphene surface with a halogen oxide radical; and functional group-introducing by introducing a functional group into a modified graphene surface.

### (1) Graphene

The graphene is a kind of carbon allotrope. Examples of the carbon allotrope other than graphene include diamond-like carbon (hereinafter, sometimes referred to as "DLC"), carbon nanotube, fullerene, nanodiamond, graphite, diamond, and carbon fiber. As described above, the production method of the present invention is characterized in that it includes the steps of: treating a surface by reacting the graphene surface with a halogen oxide radical; and introducing a functional group into a modified graphene surface. As described above, the graphene grid of the present invention is a graphene grid having a graphene surface into which a functional group is introduced.

Since graphene is extremely thinner compared with other carbon allotropes, it has an advantage that it is more likely to achieve high resolution when used for instrumental analysis such as a grid for cryo-electron microscopy. Specifically, since graphene theoretically has a thickness of only one atom, for example, the signal/noise ratio tends to be high when the graphene is used in a grid for cryo-electron microscopy. Therefore, as described above, the present invention can analyze the structural analysis target substance with high resolution.

In the present invention, the graphene may or may not include elements other than carbon. Examples of the other element include hydrogen, oxygen, nitrogen, sulfur, boron, silicon, phosphorus, and various metal elements. As to the graphene, for example, the skeleton may be formed only by a bond between carbon atoms, and the other atoms may be bonded to its surface. For example, the graphene may have groups such as a hydroxy group, a methyl group, a carboxy group, an aldehyde group, a carbonyl group, an ether bond, an ester bond, or the like on its face. When the graphene includes the other elements, the content is not particularly limited, and may be, for example, 40% or less, 20% or less, or 5% or less of the whole, for example, by the number of atoms, and may be 0.01% or more, 0.1% or more, or 1% or more of the whole, for example, by the number of atoms.

According to the surface-treating of the present invention, for example, as will be described below, a functional group such as a hydroxy group, a carboxy group, or the like can be introduced by oxidizing the graphene surface. Although this mechanism is unknown, it is presumed that, for example, a methyl group or the like of the graphene surface is oxidized and converted into a hydroxymethyl group, a carboxy group, or the like. However, this description is speculative and the present invention is not limited by this description.

### (2) Halogen Oxide Radical

In the present invention, the halogen oxide radical is contained in a reaction system of the surface-treating. For example, the halogen oxide radical may be contained in the reaction system by generating in the reaction system or by adding to the reaction system, the halogen oxide radical generated separately. How to generate the halogen oxide radical is not particularly limited. A specific example of the generation of the halogen oxide radical will be described below.

For example, as the halogen oxide radical, any one of them may be used, or two or more of them may be used in combination. The halogen oxide radical may be appropriately selected, for example, depending on the type of the graphene to be modified, the reaction conditions, and the like.

Examples of the halogen oxide radical include halogen oxide radicals such as F₂O• (oxygen difluoride radical), F₂O₂• (dioxygen difluoride radical), ClO₂• (chlorine dioxide radical), BrO₂• (bromine dioxide radical), I₂O₅• (iodine (V) oxide), and the like.

### (3) Reaction System

The reaction system in the surface-treating contains the graphene and the halogen oxide radical. The reaction system may be, as described above, for example, either a gas reaction system or a liquid reaction system. In the surface-treating, for example, the reaction system may or may not be irradiated with light. That is, the graphene and the halogen oxide radical can be reacted with each other without irradiating the graphene with light. No irradiation of the graphene with light allows, for example, safety to be improved, and costs to be reduced. For example, a halogen oxide radical may be generated by light irradiation in a radical generation reaction system that is different from the reaction system of the surface-treating so as not to irradiate the reaction system of the surface-treating with light. Note that how to generate the halogen oxide radical itself is not particularly limited as described above, and the halogen oxide radical may be generated without light irradiation.

### (3A) Gas Reaction System

When the reaction system is a gas reaction system, for example, the graphene is placed in the gas reaction system containing the halogen oxide radical and irradiated with light. In the present invention, however, the surface-treating is not limited thereto. For example, the surface-treating may be performed without light irradiation as long as the graphene surface can be reacted with the halogen oxide radical. The gas reaction system is not particularly limited as long as it contains the radical, for example, and non-limiting examples of the type of the gas phase in the gas reaction system include air, nitrogen, noble gas, and oxygen.

In the present invention, for example, the halogen oxide radical may be introduced into or generated in the gas reaction system prior to or in parallel with the surface-treating. In the former case, for example, a gas containing the halogen oxide radical may be introduced into the gas phase. In the latter case, for example, as will be described below, the halogen oxide radical generated in the radical generation reaction system in a liquid phase may be introduced by transferring the halogen oxide radical to a gas phase.

As a specific example, when the halogen oxide radical is the chlorine dioxide radical, for example, the chlorine dioxide radical may be present in the gas phase by introducing a chlorine dioxide gas into the gas phase. The chlorine dioxide radical may be generated, for example, in the gas phase by an electrochemical method.

### (3B) Liquid Reaction System

When the reaction system is the liquid reaction system, the liquid reaction system contains, for example, an organic phase. The liquid reaction system may be a one-phase reaction system containing only the organic phase, or a two-phase reaction system containing, for example, the organic phase and an aqueous phase. For the one-phase reaction system containing only the organic phase, for example, as will be described below, an aqueous phase containing a source of the halogen oxide radical may be prepared separately to generate the halogen oxide radical in the aqueous phase, and the organic phase may then be mixed with the aqueous phase to dissolve (extract), in the organic phase, the halogen oxide radical generated in the aqueous phase.

### (3B-1) Organic Phase

The organic phase contains the graphene placed therein, as described above, and is, for example, a phase of an organic solvent containing the halogen oxide radical and the graphene placed therein.

The organic solvent is not particularly limited. For example, only one type of the organic solvent may be used, or two or more types may be used in combination. In the present invention, examples of the organic solvent include a halogenated solvent and a fluorous solvent, as described above. When the liquid reaction system is the two-phase reaction system, the organic solvent is preferably, for example, a solvent that can form the two-phase system, i.e., a solvent that separates from an aqueous solvent constituting the aqueous phase described below, or a solvent that is poorly soluble or insoluble in the aqueous solvent.

The "halogenated solvent" refers, for example, to a solvent in which all or most of the hydrogen atoms of a hydrocarbon have been substituted with halogen. The halogenated solvent may be, for example, a solvent in which 50% or more, 60% or more, 70% or more, 80% or more, or 90% or more of hydrogen atoms of the hydrocarbon are substituted with halogen. The halogenated solvent is not particularly limited, and examples thereof include methylene chloride, chloroform, carbon tetrachloride, carbon tetrabromide, and a fluorous solvent described below.

The "fluorous solvent" is one of the aforementioned halogenated solvents, and is, for example, a solvent in which all or most of the hydrogen atoms of a hydrocarbon have been substituted with fluorine atoms. The fluorous solvent may be, for example, a solvent in which 50% or more, 60% or more, 70% or more, 80% or more, or 90% or more of hydrogen atoms of the hydrocarbon are substituted with fluorine atoms. In the present invention, the use of the fluorous solvent is advantageous, for example, in reducing or preventing side reactions due to the low reactivity of the fluorous solvent itself. Examples of the side reactions include an oxidation reaction of the solvent, a hydrogen abstraction reaction of the solvent with the radical, halogenation (e.g., chlorination), and a reaction of a radical derived from a raw material compound and the solvent (e.g., a reaction of an ethyl radical and the solvent, when the hydrocarbon group in the side chain or at the terminal of the graphene is an ethyl group). Since the fluorous solvent is not easily miscible with water, for example, the fluorous solvent is suitable for forming the two-phase reaction system.

Examples of the fluorous solvent include solvents represented by the following chemical formulae (F1) to (F6). Among them, the fluorous solvent is, for example, preferably CF₃(CF₂)₄CF₃ having the following chemical formula (F1) where n = 4.

| | |
|---|---|
| F₃C-(CF₂)ₙ-CF₃ | n=4, boiling point =60°C |
| | n=5, boiling point =82°C |
| | n=6, boiling point =104°C |
| | n=7, boiling point =125°C |
| (F1) | |
| 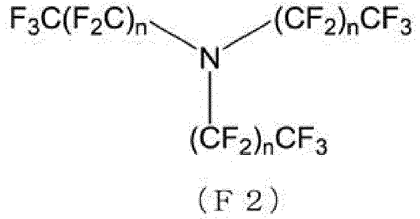 | n=1 or 4 |
| | n=1, boiling point =135°C |
| 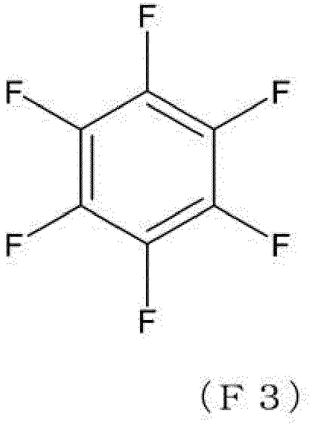 | boiling point =81°C |
| 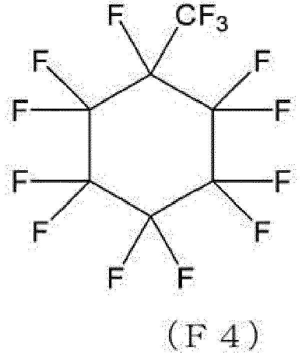 | boiling point =76°C |
| 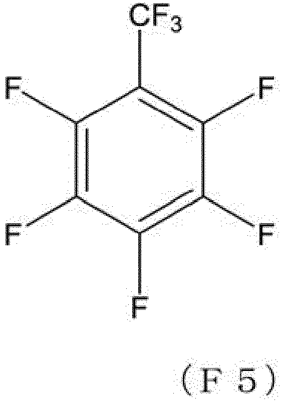 | boiling point =104°C |
| 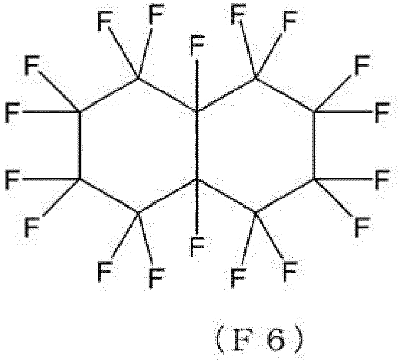 | boiling point =142°C |

The boiling point of the organic solvent is not particularly limited. The organic solvent may be appropriately selected, for example, depending on the temperature conditions in the surface-treating. For the high reaction temperature set in the surface-treating, a high boiling point solvent may be selected as the organic solvent. Note that, for example, as will be described below, for example, heating is not essential in the present invention, and the present invention can be implemented, for example, at ordinary temperature and normal pressure. In such a case, the organic solvent need not to be, for example, a solvent having a high boiling point, and a solvent having a low boiling point can be used from the viewpoint of ease of handling.

The organic phase may contain, for example, only the graphene, the halogen oxide radical, and the organic solvent, but may further contain other components. The other component is not particularly limited, and examples thereof include Brønsted acid, Lewis acid, and oxygen (O₂). In the organic phase, for example, the other components may be dissolved in the organic solvent or may be undissolved. In the latter case, the other component may be, for example, dispersed or precipitated in the organic solvent.

The organic phase contains the halogen oxide radical as described above. The organic phase may contain the halogen oxide radical, for example, by generating the halogen oxide radical in a phase other than the organic phase and extracting the halogen oxide radical. Specifically, when the reaction system is a one-phase reaction system containing only an organic phase, for example, the halogen oxide radical is generated separately in a phase other than the organic phase being the reaction system, the generated halogen oxide radical is extracted with the organic phase, and the organic phase containing the extracted halogen oxide radical as the reaction system can be used for the surface-treating. The generation of the halogen oxide radical may be performed, for example, in the aqueous phase provided separately, as will be described below. On the other hand, when the liquid reaction system is a two-phase reaction system containing the organic phase and the aqueous phase, for example, the halogen oxide radical is generated in the aqueous phase, the generated halogen oxide radical is extracted from the aqueous phase in the organic phase, and an organic phase containing the aqueous phase and the halogen oxide radical can be used for the surface-treating as the two-phase reaction system.

The graphene is placed in the organic phase. When the graphene is the molded body, the molded body is, for example, preferably fixed in the organic phase such that a portion of the molded body to be surface-treated is immersed in the organic phase and is not exposed from the organic phase, for example, from the point of view of the efficiency of the reaction process described later.

### (3B-2) Aqueous Phase

The aqueous phase is, for example, a phase of an aqueous solvent. The aqueous solvent is, for example, a solvent that is separated from the solvent used in the organic phase. Examples of the aqueous solvent include water such as H₂O and D₂O.

The aqueous phase may contain any component, for example, such as a Lewis acid, a Brønsted acid, a radical source, or the like, as described below. In the aqueous phase, these optional components may be, for example, dissolved or undissolved in the aqueous solvent. In the latter case, the optional component may be, for example, dispersed or precipitated in the aqueous solvent.

### (4) Surface-Treating

The surface-treating is reacting a surface of the graphene with a halogen oxide radical, as described above. In the surface-treating, , for example, the reaction system of the reaction may or may not be irradiated with light. While a method in which the reaction system is irradiated with light will be mainly described below, the present invention is not limited thereto. The surface-treating is not particularly limited, as described above, as long as the graphene surface can be reacted with the halogen oxide radical, and the surface-treating may be performed without light irradiation. In such cases, for example, the surface-treating can be performed without light irradiating in the following description. As described above, no irradiation of the graphene with light, for example, allows safety to be improved, and costs to be reduced.

The reaction system contains the graphene placed therein, and the graphene may be modified. Specifically, the present invention allows the graphene to be modified easily in the presence of the halogen oxide radical. The present invention allows, for example, the degree of modification of the graphene (e.g., the degree of modification such as oxidation) to be easily adjusted through adjustment of the amount of the halogen oxide radical, the light irradiation time, and the like. Thus, for example, decomposition of the graphene due to excessive oxidation or the like can be prevented, and, for example, the characteristic inherent in the graphene can be prevented from being impaired.

In the surface-treating, when a methyl group is present on the graphene surface, a methyl group (-CH₃) is oxidized into, for example, at least one of a hydroxymethyl group (-CH₂OH), a formyl group (-CHO), and a carboxyl group (-COOH). This presumes the following mechanism. For example, the light irradiation generates a radical of the halogen (e.g., a chlorine radical (Cl•)) and a molecule of the oxygen from the halogen oxide radical (e.g., a chlorine dioxide radical). Then, in the methyl group (-CH₃) on the graphene surface, a radical of the halogen (e.g., a chlorine radical (Cl•)) functions as a hydrogen extracting agent and becomes a carbo radical (-CH₂•), and then a molecule of the oxygen (e.g., O₂) functions as an oxidizing agent and becomes a hydroxymethyl group (-CH₂OH). The hydroxymethyl group (-CH₂OH) is further oxidized to a formyl group (-CHO) or a carboxy group (-COOH).

When an ethyl group is present on the graphene surface in the surface-treating, the ethyl group (-CH₂CH₃) is oxidized into, for example, a hydroxyethyl group (-CH₂CH₂OH), an acetaldehyde group (-CH₂CHO), or a carboxymethyl group (-CH₂COOH).

Further, for example, when the graphene surface has a methylene group (-CH₂-), for example, the methylene group is oxidized into a hydroxymethylene group (-CHOH-), a carbonyl group (-CO-), or the like.

In the surface-treating, the conditions of light irradiation are not particularly limited. The wavelength of the irradiation light is not particularly limited, and the lower limit is, for example, 200 nm or more and the upper limit is, for example, 800 nm or less. The light irradiation time is not particularly limited, and the lower limit is, for example, 1 second or more, the upper limit is, for example, 1000 hours. The reaction temperature is not particularly limited, and the lower limit is, for example, -20°C or more, the upper limit is, for example, 100°C or less or 40°C or less, and the reaction temperature is, for example, in a range from 0°C to 100°C, or from 0°C to 40°C. The atmospheric pressure at the time of the reaction is not particularly limited, and the lower limit is, for example, 0.1 MPa or more, the upper limit is, for example, 100 MPa or less, 10 MPa or less, or 0.5 MPa or less, and the atmospheric pressure is, for example, in the range from 0.1 to 100 MPa, 0.1 to 10 MPa, or 0.1 to 0.5 MPa. The reaction conditions during the surface-treating are, for example, a temperature from 0°C to 100°C or from 0°C to 40°C, and a pressure from 0.1 to 0.5 MPa. As described above, for example, the surface-treating itself can be performed without light irradiation. The present invention, for example, allows the surface-treating or all steps including the surface-treating to be performed at normal temperature (room temperature) and normal pressure (atmospheric pressure) without heating, pressurizing, or decompressing. The term "room temperature" is not particularly limited, and is, for example, 5°C to 35°C. Therefore, even if the graphene includes, for example, a graphene having low heat resistance, it can be applied to the present invention. Further, the present invention, for example, allows the surface-treating or all steps including the surface-treating to be performed in atmosphere without substitution with inactive gas.

The light source of the light irradiation is not particularly limited, and, for example, visible light included in natural light such as sunlight can be used. The natural light, for example, allows excitation to be performed in a simplified manner. Further, as the light source, for example, as a substitute for or in addition to the natural light, light sources such as a xenon lamp, a halogen lamp, a fluorescent lamp, a mercury lamp, and an LED lamp can be used. In the light irradiation, for example, a filter for cutting wavelengths other than the necessary wavelengths further can be used as appropriate.

In the present invention, by irradiating only a freely-selected area of the graphene, only the freely-selected area can be modified. Such a method of controlling selective light irradiation is not particularly limited, and for example, only a freely-selected area may be irradiated with light, or only an area not to be irradiated with light may be masked and the whole area of the graphene may be irradiated with light.

When the reaction system is the liquid reaction system, for example, at least the organic phase may be irradiated with light in the surface-treating. In the case of a one-phase reaction system consisting only of the organic phase, for example, the surface-treating can be performed by irradiating the one-phase reaction system with light. In the case of a two-phase reaction system containing the organic phase and the aqueous phase, for example, only the organic phase may be irradiated with light, or the two-phase reaction system may be irradiated with light. In the case of the liquid reaction system, for example, the liquid reaction system may be irradiated with light while bringing the liquid reaction system into contact with air, and in the case of the two-phase reaction system, the liquid reaction system may be irradiated with light in a state where oxygen is dissolved in the aqueous phase.

The surface-treating of the present invention can modify the graphene by generating a radical of the halogen (e.g., a chlorine atom radical Cl•) and an oxygen molecule O₂ through, for example, really simple light irradiation in the presence of the halogen oxide radical to bring the graphene to react (e.g., oxidize). Then, for example, the present invention can change and modify the graphene efficiently in a simplified manner even under extremely mild conditions such as normal temperature and normal pressure.

According to the present invention, for example, a substance with a modified graphene surface is obtained without using a toxic heavy metal catalyst or the like. Therefore, as described above, for example, the graphene can be modified efficiently with the low load on the environment in addition to the reaction being performed under the very mild conditions.

As a method of oxidizing the graphene surface, for example, there is a method of using a strong oxidizing agent such as potassium permanganate (KMnO₄), a method using plasmatreatment in a gas phase, and a method using UV irradiation in an ozone-atmosphere. However, such methods do not stay with the oxidation of the graphene surface, but may cleave the carbon-carbon bond of the skeleton and may decompose the graphene. In contrast, according to the surface-treating of the present invention, since the reaction can be performed under mild reaction conditions as described above, it is possible to suppress or prevent the cleavage of the carbon-carbon bond of the graphene skeleton. Further, according to the surface-treating of the present invention, it is easy to control the reaction conditions. Specifically, for example, the reaction in the surface-treating can be optionally stopped by stopping the light irradiation, stopping the supply of the halogen oxide radical, and the like. Thus, for example, the cleavage of the carbon-carbon bond of graphene skeleton can be further suppressed, and, for example, the progress of the reaction of the graphene surface can be easily controlled. Therefore, according to the present invention, for example, it is possible to efficiently modify the graphene surface without decomposing graphene. The fact that the deterioration (decomposition, etc.) of graphene after the surface-treating is low can be verified by, for example, observing the graphene surface after the surface-treating by AFM (atomic force microscopy). Further, for example, in a treatment that requires several tens of minutes, such as oxidation by liquid phase treatment using potassium permanganate, ultraviolet (UV) irradiation in an ozone atmosphere, and the like, by using the surface-treating of the present invention, it becomes possible to modify the graphene surface (oxidation reaction), for example by gas phase treatment (dry process), simply and in a short time (within a few minutes), while maintaining the graphene structure. Thus, for example, a functional group can be effectively introduced in the functional group-introducing. This description, however, is merely an example, and does not limit the present invention. For example, the reaction system in the surface-treating of the present invention is not limited to the gas reaction system (gas phase treatment) as described above, and may be a liquid reaction system.

### (5) Halogen Oxide Radical-Generating

The present invention, for example, may further include a step of generating a halogen oxide radical. The halogen oxide radical-generating may be, for example, performed prior to or in parallel with the surface-treating. How to generate the halogen oxide radical is not particularly limited.

In the halogen oxide radical-generating, for example, the halogen oxide radical may be generated using a radical generation reaction system. The reaction system in the surface-treating may be, for example, either the gas reaction system (gas phase) or the liquid reaction system (liquid phase). The radical generation reaction system after the generation of the halogen oxide radical may be, for example, used as it is as the liquid reaction system in the surface-treating.

When the reaction system in the surface-treating is the gas reaction system, for example, the radical generation reaction system may be prepared separately from the reaction system in the surface-treating. The radical generation reaction system may be, for example, an aqueous phase containing a source of the halogen oxide radical. The aqueous phase includes, for example, a source of the halogen oxide radical, and in the generating the halogen oxide radical, the halogen oxide radical is generated from the source. The aqueous phase is, for example, a phase of an aqueous solvent, and the aqueous solvent is the same as that described above. When the halogen oxide radical generated in the aqueous phase is hydrophobic, for example, the halogen oxide radical may be transferred into the organic phase using a two-phase reaction system containing the organic phase and the aqueous phase. As described above, in the case where the surface-treating is performed in the gas reaction system, the halogen oxide radical generation reaction system may be for example, either only an aqueous phase or a two-phase reaction system of an aqueous phase and an organic phase. When the halogen oxide radical is hydrophobic, for example, since the radical generated in the aqueous phase can move directly to the gas phase, the radical generation reaction system may have only the aqueous phase.

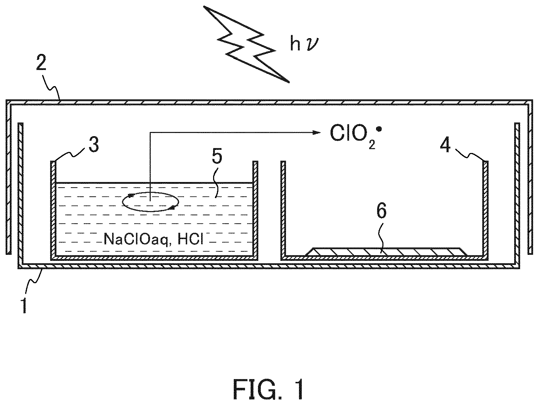

The reaction system in the surface-treating and the radical generation reaction system may be, for example, the reaction system shown in FIG. 1. Specifically, first, a radical generation reaction system 5 is placed in a petri dish 3 as shown in FIG. 1. The radical generation reaction system 5 may be, for example, an aqueous phase containing a source of the halogen oxide radical. The source of the halogen oxide radical is not particularly limited, and is, for example, as described below. Meanwhile, a graphene 6 is placed in another petri dish 4. These petri dishes 3 and 4 are housed in yet another large petri dish 1, and a lid 2 is placed to prevent gas inside the petri dish 1 from leaking. Thereafter, the radical generation reaction system 5 in the petri dish 3 is irradiated with light. By this light irradiation, a gas of halogen oxide radical is generated in the petri dish 3, and the gas of the halogen oxide radical flows into the petri dish 4 to react with graphene 6. In this manner, the surface-treating can be performed. FIG. 1 illustrates an example in which the source of the halogen oxide radical in the radical generation reaction system 5 is a sodium chlorite aqueous solution (NaClO₂aq) and hydrochloric acid (HCl), and the halogen oxide radical generated by these reactions is a chlorine dioxide radical (ClO₂). However, as described above, in the present invention, the source of the halogen oxide radical and the halogen oxide radical are not limited thereto.

When the reaction system in the surface-treating is the liquid reaction system which contains an aqueous phase, for example, the aqueous phase may be the radical generation reaction system. When the reaction system in the surface-treating is the gas reaction system, the aqueous phase may be, for example, the same as the radical generation reaction system. When the halogen oxide radical generated in the aqueous phase is hydrophobic, for example, the halogen oxide radical may be transferred into the organic phase using a two-phase reaction system containing the organic phase and the aqueous phase.

The source of the halogen oxide radical (radical generation source) is not particularly limited, and may be, for example, selected, as appropriate, according to the type of the halogen oxide radical. For example, one type or two or more types of the source of the halogen oxide radical may be used in combination.

The source of the halogen oxide radical is, for example, a compound containing oxygen and halogen, and can be halous acid (HXO₂) or a salt thereof as a specific example. The salt of the halous acid is not particularly limited, and may be, for example, a metal salt, and examples of the metal salt include alkaline metal salts, alkaline earth metal salts, and rare earth salts. The source of the halogen oxide radical may be, for example, a compound containing oxygen, halogen, and a Group 1 element (e.g., at least one selected from the group consisting of H, Li, Na, K, Rb, and Cs), and can be, for example, the halous acid or an alkaline metal salt thereof. When the halogen oxide radical is the chlorine dioxide radical, the source is not particularly limited, and may be, for example, chlorous acid (HClO₂) or salts thereof, and specific examples thereof include sodium chlorite (NaClO₂), lithium chlorite (LiClO₂), potassium chlorite (KClO₂), magnesium chlorite (Mg(ClO₂)₂), and calcium chlorite (Ca(ClO₂)₂). Among them, from the viewpoint of cost, ease of handling, and the like, sodium chlorite (NaClO₂) is preferred. For example, a similar salt or the like can be employed for the source of other halogen oxide radicals. Examples of other source include bromates such as sodium bromate and the like, and iodates such as sodium iodate and the like.

The concentration of the source in the aqueous phase is not particularly limited. When the source is a compound, in terms of the halogen oxide ion concentration, for example, the lower limit of the concentration thereof is 0.0001 mol/L or more and the upper limit thereof is 1 mol/L or less, and, in terms of the molar amount of the halogen oxide ion, for example, the lower limit of the concentration thereof is 1/100000 times or more of the molar amount of the raw material and the upper limit of the concentration thereof is 1000 times or less of the molar amount of the raw material. When the source is halous acid or a halous acid salt (e.g., chlorous acid or chlorite), in terms of a halous acid ion (e.g., chlorite ion (ClO₂-)) concentration, for example, the lower limit of the concentration thereof is 0.0001 mol/L or more and the upper limit of the concentration thereof is 1 mol/L or less, and in terms of the number of moles of the halous acid ion (e.g., chlorite ion (ClO₂-)), for example, the lower limit of the concentration thereof is 1/100000 times or more of the number of moles of the raw material and the upper limit of the concentration thereof is 1000 times or less of the number of moles of the raw material. The above-described concentrations can be, for example, applied also to other sources.

The aqueous phase may further contain, for example, at least one of Lewis acid and Brønsted acid, which may act on the halogen oxide ion to generate the halogen oxide radical. At least one of the Lewis acid or Brønsted acid is, for example, at least one of Lewis acid and Brønsted acid containing the Group 1 element. The halogen oxide ion is, for example, a chlorite ion (ClO₂-). The aqueous phase contains, for example, either one of or both of the Lewis acid or Brønsted acid, or one substance serving as both of the Lewis acid and Brønsted acid. Only one type each of the Lewis acid and Brønsted acid may be used, or two or more types each of the Lewis acid and Brønsted acid may be used in combination. In the present invention, the "Lewis acid" refers to, for example, a substance serving as Lewis acid for the source of the halogen oxide radical.

The concentration of at least one of the Lewis acid and Brønsted acid in the aqueous phase is not particularly limited and can be set, for example, as appropriate, according to the type of the graphene to be modified. The lower limit of the concentration is, for example, 0.0001 mol/L or more and the upper limit of the concentration is, for example, 1 mol/L or less.

The Brønsted acid is not particularly limited, and may be, for example, an inorganic acid or an organic acid. Specific examples of the Brønsted acid include trifluoromethanesulfonic acid, trifluoroacetic acid, acetic acid, hydrofluoric acid, hydrochloric acid, hydrobromic acid, hydroiodic acid, sulfuric acid, sulfurous acid, nitric acid, nitrous acid, phosphoric acid, and phosphorous acid. The acid dissociation constant pKₐ of the Brønsted acid is, for example, 10 or less. The lower limit of the pKₐ is not particularly limited, and is, for example, -10 or more.

It is preferred that the aqueous phase contains, for example, the halogen oxide ion and the Brønsted acid, and is, for example, an aqueous phase obtained by dissolving the compound and the Brønsted acid (e.g., hydrochloric acid) in an aqueous solvent. As a specific example, when the halogen oxide radical is a chlorine dioxide radical, it is preferred that the aqueous phase contains, for example, chlorite ion (ClO₂-) and Brønsted acid, and is, for example, an aqueous phase obtained by dissolving the sodium chlorite (NaClO₂) and the Brønsted acid (e.g., hydrochloric acid) in an aqueous solvent.

In the aqueous phase, the Lewis acid, the Brønsted acid, the radical generation source, and the like may be, for example, dissolved or undissolved in the aqueous solvent. In the latter case, these may be, for example, dispersed or precipitated in the aqueous solvent.

The halogen oxide radical-generating is not particularly limited, and may be performed by bringing the source of the halogen oxide radical to be contained in the aqueous solvent to naturally generate the halogen oxide radical (e.g., a chlorine dioxide radical) from the halogen oxide ion (e.g., a chlorite ion). For example, it is preferable that the source be dissolved in the aqueous solvent in the aqueous phase, and it is preferable that the aqueous phase be left to stand. In the halogen oxide radical-generating, , for example, the coexistence of at least one of the Lewis acid and the Brønsted acid in the aqueous phase allows the generation of the halogen oxide radical to be further promoted. In the halogen oxide radical-generating, for example, the irradiation of the aqueous phase with light also allows the generation of the halogen oxide radical, but mere standing still of the aqueous phase also allows the generation of the halogen oxide radical.

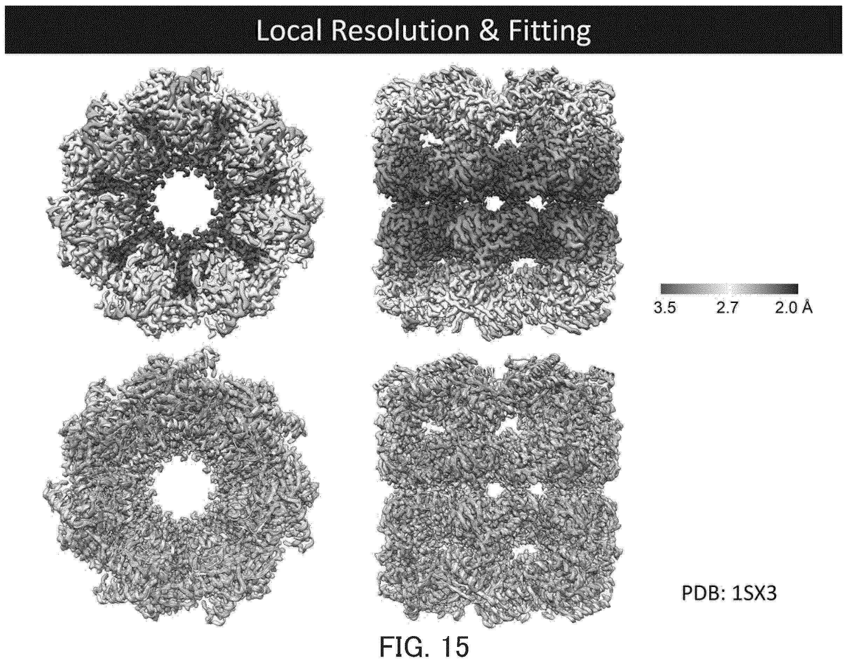

The mechanism of generating the halogen oxide radical from the halogen oxide ion in the aqueous phase is presumed to be the same as that in FIG. 15 (a liquid phase reaction system, a two-phase system of an organic phase and an aqueous phase), for example, which will be described below. It is to be noted, however, that this description is merely an illustrative example, and by no means limits the present invention thereto.

When the reaction system is the liquid reaction system, and a two-phase reaction system of the organic phase and the aqueous phase, as described above, the liquid reaction system after generation of the halogen oxide radical may be applied as it is to the surface-treating. Since the halogen oxide radical generated from the source in the aqueous phase in the reaction system is hardly dissolved in water, the halogen oxide radical is dissolved in the organic phase in the reaction system. For example, in the liquid reaction system generating the halogen oxide radical, it is possible to perform the surface-treating that modifies a surface of graphene further by irradiating light. In such a case, for example, the halogen oxide radical-generating and the surface-treating can be performed continuously by irradiating the liquid reaction system with light. In the present invention, the halogen oxide radical-generating and the surface-treating in the two-phase reaction system achieve, for example, higher reaction efficiency.

On the other hand, when the reaction system in the surface-treating is the liquid reaction system, and also is a one-phase reaction system only containing the organic phase, for example, a halogen oxide radical is generated in the aqueous phase in the manner described above, the generated halogen oxide radical is dissolved (extracted) in the organic phase, the aqueous phase is then removed, and the organic phase containing the halogen oxide radical may be used, as said one-phase reaction system, for the surface-treating.

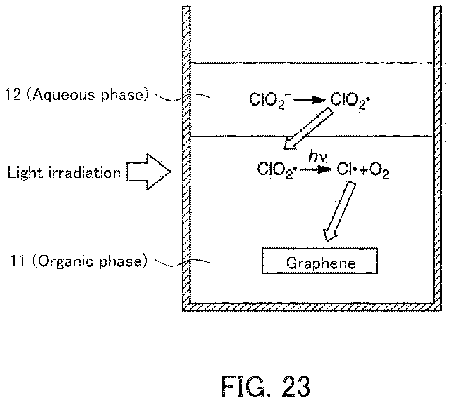

FIG. 23 schematically illustrates an example of the halogen oxide radical-generating and the surface-treating using the two-phase reaction system. While FIG. 23 shows the chlorine dioxide radical as a specific example of the halogen oxide radical, the present invention is not limited by this example. As shown in FIG. 23, in the reaction system, two layers of an aqueous layer (the aqueous phase) and an organic layer (the organic phase) are separated in a reaction container, and are in contact with each other only at interfaces. An upper layer is the aqueous layer (the aqueous phase) 12, and a lower layer is the organic layer (the organic phase) 11. It is to be noted that, while FIG. 23 is a cross-sectional view, for viewability, hatching of the aqueous layer 12 and organic layer 11 is omitted. Because the chlorine dioxide radical (ClO₂•) is waterinsoluble, it dissolves in the organic layer 11. Subsequently, by irradiating the organic layer 11 containing the chlorine dioxide radical (ClO₂·) with light and applying light energy to the organic layer 11, the chlorine dioxide radical (ClO₂·) in the organic layer 11 is decomposed, thereby generating a chlorine radical (Cl·) and an oxygen molecule (O₂). Thus, a graphene in the organic layer (organic phase) 11 is oxidized, and the surface is modified. It is to be noted, however, that FIG. 23 shows merely an illustrative example and by no means limits the present invention.

While the aqueous layer 12 is the upper layer and the organic layer 11 is the lower layer in FIG. 23, for example, if the organic layer 11 has lower density (specific gravity) than the aqueous layer 12, the organic layer 11 serves as the upper layer. The graphene may be immobilized in the reaction vessel such that the graphene is placed in the upper organic layer. In this case, the site where the graphene is immobilized may be, for example, provided in the reaction vessel or may be provided outside the reaction vessel. In the latter case, for example, the graphene may be suspended from the outside and immersed in the organic layer.

Although FIG. 23 shows the two-phase reaction system, the surface-treating may also be performed in a one-phase reaction system containing only an organic phase in the production method according to the present invention. In this case, for example, an aqueous phase containing a source of the halogen oxide radical is prepared separately to generate the halogen oxide radical in the aqueous phase, the organic phase is then mixed with the aqueous phase to dissolve (extract), in the organic phase, the halogen oxide radical generated in the aqueous phase. Then, the aqueous phase and the organic phase are separated from each other, the organic phase is recovered, and the graphene is placed therein. Using this as a one-phase reaction system, the surface-treating is independently performed by light irradiation in the presence of the halogen oxide radical. When the reaction system in the surface-treating is the gas reaction system, as described above, the surface-treating may be performed in the gas reaction system after generation of the halogen oxide radical in the aqueous phase.

As a method of oxidizing the graphene surface, for example, there are a method of using a strong oxidizing agent such as potassium permanganate (KMnO₄), a method using plasmatreatment in a gas phase, and a method using UV irradiation in an ozone-atmosphere. However, such a method does not stay with the oxidation of the graphene surface, but may cleave the carbon-carbon bond of the skeleton thereof and may decompose the graphene. In contrast, according to the surface-treating of the present invention, since the reaction can be performed under mild reaction conditions as described above, it is possible to suppress or prevent the cleavage of the carbon-carbon bond of the graphene skeleton. Further, according to the surface-treating of the present invention, it is easy to control the reaction conditions. Specifically, for example, the reaction in the surface-treating can be optionally stopped by stopping the light irradiation, stopping the supply of the halogen oxide radical, or the like. Thus, for example, the cleavage of the carbon-carbon bond of graphene skeleton can be further suppressed, and, for example, the progress of the reaction of the graphene surface can be easily controlled. Therefore, according to the present invention, for example, it is possible to efficiently modify the graphene surface without decomposing graphene. The fact that the deterioration (decomposition, etc.) of graphene after the surface-treating is low can be verified by, for example, observing the graphene surface after the surface-treating by AFM (atomic force microscopy). Further, for example, in a treatment that requires several tens of minutes, such as oxidation in a liquid phase using potassium permanganate, ultraviolet (UV) irradiation in an ozone atmosphere, and the like, by using the surface-treating of the present invention, it also is possible to modify the graphene surface (oxidation reaction), for example by gas phase treatment (dry process), simply and in a short time (within a few minutes), while maintaining the graphene structure. Thus, for example, a functional group can be effectively introduced in the functional group-introducing. This description, however, is merely an example, and does not limit the present invention. For example, the reaction system in the surface-treating of the present invention is not limited to the gas reaction system (gas phase treatment) as described above, and may be a liquid reaction system.

As described above, the method for producing a graphene grid according to the present invention, for example, can efficiently modify the graphene surface without decomposing graphene by the surface-treating. Thus, for example, as will be described below, the structural analysis target substance can be firmly immobilized at a high concentration to the surface of the cryo-electron microscopy, and uneven distribution (localization, e.g., flocculation, etc.), uneven orientation, and the like of the structural analysis target substance can be suppressed or prevented. This makes it possible, for example, to dramatically reduce the time required for an optimization screening of measurement conditions for cryo-electron microscopy compared with conventional methods. In addition, it is possible to reduce the time required for data collection for structural analysis.

### [2. Method for Producing Graphene Grid]

As described above, the method for producing a graphene grid according to the present invention (the production method of the present invention) is a method for producing a graphene grid formed of a substance having a graphene surface into which a functional group is introduced, including the steps of: surface-treating by reacting a graphene surface with a halogen oxide radical to modify the graphene surface; and functional group-introducing by introducing a functional group into the modified graphene surface.

By introducing the functional group, various functions can be imparted to the graphene. Specifically, for example, as shown in Examples to be described below, the functional group makes it easy to capture a structural analysis target substance (e.g., a protein) to be analyzed by cryo-electron microscopy. In addition, for example, by appropriately selecting the type of the functional group, any function corresponding to the type of the functional group can be imparted.

In the functional group-introducing, for example, a functional group can be introduced into an oxidized (modified) graphene surface into which a substituent such as a hydroxy group, a carboxy group, or an aldehyde group (formyl group) has been introduced through a reaction (e.g., condensation reaction) between the substituent such as the hydroxy group, the carboxy group, or the aldehyde group and another substance. According to this, for example, any functional group that can be introduced through a reaction with the substituent (e.g., a hydroxy group, a carboxy group, an aldehyde group, or the like) having been introduced into the graphene surface can be introduced.

Examples of the functional group-introducing include those described in Examples to be described below. Specifically, for example, as described in the following Examples, the hydrogen of the hydroxyl group introduced into the graphene surface can be substituted with a 2,3-epoxypropyl group, and then the addition reaction can be performed between the epoxy group and a protein or 1H,1H-undecafluorohexylamine. Amine is not limited to 1H,1H-undecafluorohexylamine, and any other amine may be used. The amine is not particularly limited, and may be, for example, a primary amine or a secondary amine. Furthermore, the present invention is not limited thereto as long as it is within the scope of the present invention.

Further, a functional group to be introduced by the functional group-introducing is not particularly limited, and for example, as described above, any functional group that can be introduced through a reaction with the substituent having been introduced into the graphene surface (e.g., a hydroxy group, a carboxy group, an aldehyde group, or the like) can be introduced. As described above, the functional group to be introduced in the functional group-introducing may be at least one selected from the group consisting of a hydroxy group, a carboxyl group, an aldehyde group, a carbonyl group, an ether bond, an ester bond, an amino group, an imino group, a sulfonyl group, a sulfonyloxy group, and a fluoroalkyl group. The fluoroalkyl group, for example, may be a group in which some or all of the hydrogen atoms of the alkyl group are substituted with fluorine atoms, may be a perfluoroalkyl group in which all of the hydrogen atoms of the alkyl group are substituted with fluorine atoms, and may be a trifluoromethyl group. The functional group, for example, may be a combination of two or more functional groups, may be a trifluoroacetyl group that is a combination of a trifluoromethyl group and an ester bond, or may be a trifluoromethylsulfonyl group that is a combination of a trifluoromethyl group and a sulfonyl group. In the present invention, the number of carbon atoms of the "alkyl group" is not particularly limited, and may be, for example, 1 to 24, 1 to 18, 1 to 12, 1 to 6, or the like, and the "alkyl group" may be linear or branched. The same applies to a group (e.g., a fluoroalkyl group) in which at least one hydrogen atom of the alkyl group is substituted. Specifically, for example, as a functional group introduced in the functional group- introducing, a succinimidyl group, an isothiocyano group, a sulfonic acid chloride group, a carboxylic acid chloride group, an ethylene oxide group, an alkyl chloride group, a carboxylic acid anhydride group, a maleimide group, or a hydrazide can be introduced into the graphene surface through a reaction with a substituent such as a hydroxy group, a carboxy group, or an aldehyde group of the graphene surface. Since the functional group thus introduced can react with a group such as an amino group, a sulfhydryl group (also referred to as "-SH", "a mercapto group", or "a thiol group"), an aldehyde group, or the like, for example, a compound having these groups (e.g., a protein or the like) can be bonded and captured.

The reaction conditions in the functional group-introducing are not particularly limited, and can be set appropriately. The reaction conditions may be, for example, the same as or similar to the reaction conditions of existing identical or similar reactions. For example, when a functional group is introduced through a reaction with a hydroxy group or a carboxy group, reaction conditions the same as or similar to the reaction conditions for an conventional reaction of a hydroxy group or a carboxy group may be used.

The graphene grid produced by the production method of the present invention can be used, for example, as a grid for cryo-electron microscopy. For example, during the structural analysis by cryo-electron microscopy, a structural analysis target substance to be analyzed by cryo-electron microscopy can be bonded to a grid for cryo-electron microscopy (graphene grid) produced by the production method of the present invention to use. The grid for cryo-electron microscopy produced by the production method of the present invention may be a graphene grid to which a structural analysis target substance to be analyzed by cryo-electron microscopy is bonded, or may be a graphene grid to which a structural analysis target substance to be analyzed by cryo-electron microscopy is not bonded.

### [3. Graphene Grid (e.g. Grid for Cryo-Electron Microscopy)]

As described above, the graphene grid of the present invention is a graphene grid having a graphene surface into which a functional group is introduced. The graphene grid of the present invention can be used, for example, as a grid for cryo-electron microscopy. For example, during the structural analysis by cryo-electron microscopy, a structural analysis target substance to be analyzed by cryo-electron microscopy can be bonded to the grid for cryo-electron microscopy (graphene grid) of the present invention to use. Further, as described above, the graphene grid of the present invention may be, for example, a grid for cryo-electron microscopy obtained by binding a structural analysis target substance to be analyzed by cryo-electron microscopy to the graphene grid of the present invention. The grid for cryo-electron microscopy of the present invention may be a graphene grid to which a structural analysis target substance to be analyzed by cryo-electron microscopy is bonded, or may be a graphene grid to which a structural analysis target substance to be analyzed by cryo-electron microscopy is not bonded.

The method for producing a graphene grid of the present invention is not particularly limited, and the graphene grid can be produced, for example, by the method for producing a graphene grid of the present invention. This production method includes, as described above, the steps of surface-treating and functional group-introducing.

Further, for example, it is also possible to produce a graphene grid of the present invention by performing the functional group-introducing on the graphene without performing the surface-treating. More specifically, for example, if the graphene surface that is not subjected to the surface-treating has substituents such as a hydroxy group, a carboxy group, and the like, the graphene grid of the present invention can be produced by performing the functional group-introducing on those substituents.

For exampli, by binding a structural analysis target substance to be analyzed by cryo-electron microscopy to the functional group, graphene grid of the present invention can suppress or prevent uneven distribution, uneven orientation, and the like of the structural analysis target substance. The bond between the functional group and the structural analysis target substance is not particularly limited, and examples thereof include a covalent bond, an ionic bond, a metal coordination bond, a host-guest interaction, and a hydrogen bond, and the covalent bond is particularly preferred from the viewpoint of strength of the bond.

In the graphene grid of the present invention, a structural analysis target substance to be analyzed by cryo-electron microscopy is covalently bonded to the functional group, which provides the following advantages. First, when the structural analysis target substance is bonded to the functional group by a covalent bond, the structural analysis target substance is less likely to fall off even when the surface of the cryo-electron microscopy is washed. Therefore, by the washing, it is possible to wash off unnecessary impurities (e.g., proteins denatured at the gasliquid interface) which are not covalently bonded to the surface of the cryo-electron microscope., which allows structural analysis with high accuracy. Second, even if the structural analysis target substance is a substance that is difficult to concentrate (e.g., a protein that is difficult to concentrate, etc.), the structural analysis target substance can be introduced into the surface of the cryo-electron microscope at a high concentration by repeatedly forming a covalent bond to the functional group. As a result, for example, it is possible to dramatically reduce the time required for optimization screening of measurement conditions for cryo-electron microscopy and data collection for structural analysis. Third, since the structural analysis target substance can be firmly immobilized to the surface of the cryo-electron microscopy by the covalent bond, uneven distribution (localization, e.g., flocculation, etc.), uneven orientation, and the like of the structural analysis target substance can be suppressed or prevented. Therefore, it is possible to analyze the structural analysis target substance with high accuracy and high resolution. Fourth, for example, by having the first to third features, for example, as demonstrated in Examples to be described below, it is possible to analyze the structural analysis target substance with high accuracy and high resolution even without introducing a tag or the like into the structural analysis target substance (e.g., protein). Since the step of introducing a tag or the like into the structural analysis target substance becomes unnecessary, the measurement sample (the grid for cryo-electron microscopy of the present invention to which the structural analysis target substance is bonded) can be easily produced in a short time. Thus, according to the present invention, for example, it is possible to dramatically reduce the time for preparing a measurement sample for cryo-electron microscopy as compared with a conventional one, and it is possible to prepare the measurement sample by an operation easier than a conventional method. The present invention, however, is not limited to an aspect of not introducing a tag or the like into the structural analysis target substance, and the structural analysis may be conducted by introducing a tag or the like into the structural analysis target substance (e.g., a protein).

Since conventional carbon grids for cryo-electron microscopy had a weak binding force between the grid and the structural analysis target substance, as described above, it was possible that uneven distribution (localization), uneven orientation, and the like of the structural analysis target substance on the carbon grid occur, which may hinder the structural analysis. In contrast, the graphene grid of the present invention can strongly bind with the structural analysis target substance as described above. Thereby, uneven distribution, uneven orientation, and the like of the structural analysis target substance can be suppressed or prevented.

The method of binding the structural analysis target substance to the functional group is not particularly limited. For example, depending on the combination of the functional group and the structural analysis target substance, the same or similar reaction conditions as those of known similar reactions can be appropriately set. For example, the graphene grid of the present invention having the functional group may be immersed in a solution (e.g., an aqueous solution) of the structural analysis target substance for an appropriate time, however, the present invention is not limited to this method.

The structural analysis target substance is not particularly limited, and may be, for example, the same as or different from a general structural analysis target substance of cryo-electron microscopy. Examples of the structural analysis target substance include proteins, antibodies, nucleic acids, viruses, ribosomes, mitochondria, ion channels, enzymes, and enzyme complexes. Examples of the protein include, in the case of classifying by physical properties, membrane proteins, water-soluble proteins, and glycoproteins, and include, in the case of classifying by functions, enzymatic proteins, structural proteins, transcription factors, transporting proteins, storage proteins, contractile proteins, and protection proteins. Examples of the protein include, besides apoferritin used as a reference protein for analysis, ribosomes, proteasomes, RNA polymerases, capsids, GPCR, photochemical complexes, ATP synthetases, and complexes with antibodies. In addition to them, tubulin or the like composed of these can be the structural analysis target substance in the present invention. Further, examples of the structural analysis target substance in the present invention include tissue itself such as muscle, collagen, and flagella. Moreover, for example, a living body itself, a tissue surface, or the like can be used as the structural analysis target substance in the present invention by using an antibody or the like, as a labeled protein.

The graphene grid of the present invention can suppress or prevent the uneven distribution, uneven orientation, and the like of the structural analysis target substance as described above. Further, the grid for cryo-electron microscopy of the present invention can analyze the structure of a substance that has been difficult to be analyzed by a conventional grid for cryo-electron microscopy. For example, since a membrane protein and the like are difficult to crystallize, it has been difficult to analyze the three-dimensional structure of the membrane protein by a conventional grid for cryo-electron microscopy. In contrast, since the graphene grid of the present invention can strongly bind to a structural analysis target substance such as the membrane protein to stabilize the structure, the structural analysis can be performed, and for example, three dimensional structural analyses can be performed. Further, the graphene grid of the present invention can perform, for example, a single particle analysis of a protein or the like.

The usage of the graphene grid of the present invention is not particularly limited, and may be, for example, the same method as that of a general grid for cryo-electron microscopy. For example, similar to a general grid for cryo-electron microscopy, a structural analysis can be performed by observing the captured structural analysis target substance by a microscopy using the Vitreous Ice Embedding method.

In the present invention, for example, as described above, it is possible to conduct structural analysis with high accuracy and high resolution without adding a tag or the like to a protein. However, as described above, the present invention is not limited to an aspect of not introducing a tag or the like into the structural analysis target substance, and the structural analysis may be conducted by introducing a tag or the like into the structural analysis target substance (e.g., a protein).

Further, the use of the graphene grid of the present invention is not limited to a grid for cryo-electron microscopy, and can be used in any wide range of applications, and can be used, for example, in applications such as a bioreactor, a sensor (e.g., a biosensor such as an enzyme sensor), a microreactor, and the like, and also in detection reagents when an antibody or various proteins are linked to a bead or the like, affinity column chromatography, and the like.

### Examples

Next, Examples of the present invention will be described. It is to be noted, however, that the present invention is by no means limited to the following examples.

### Reference Example 1

A graphene surface was modified by the surface-treating of the present invention to produce a substance with a modified graphene surface.

In the present reference example, the surface-treating using a reaction in a gas phase was performed.

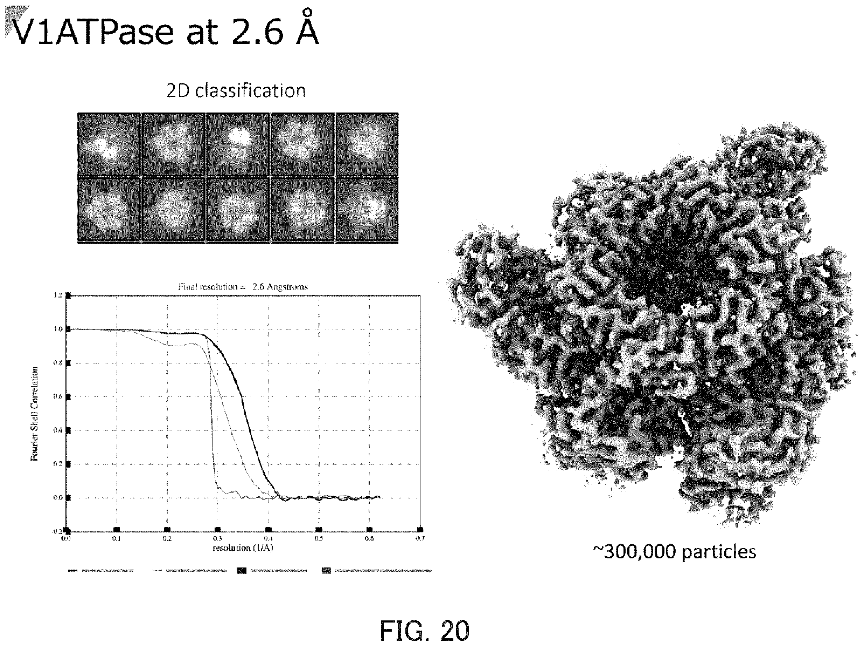

First, as shown in FIG. 1, 20 mL of deionized water was added to a 5-cm-diameter petri dish 3, and then sodium chlorite (NaClO₂) (300mg) and a 36% by mass HCl aqueous solution (100 µL) were dissolved to obtain a hydrochloric acid acidic NaClO₂ aqueous solution (radical generation reaction system) 5. On the other hand, 10 mg of the graphene 6 was placed in a 3-cm-diameter petri dish 4. These petri dishes 3 and 4 were housed in a 11-cm-diameter petri dish 1. In addition, a lid 2 was placed on the petri dish 1 to prevent gas inside the petri dish 1 from leaking. Thereafter, the hydrochloric acid acidic NaClO₂ aqueous solution 5 in the petri dish 3 was irradiated from above the petri dish 1 with an LED light having a wavelength of 365 nm for 3 minutes, 10 minutes, 30 minutes, or 60 minutes at room temperature and at a light amount of 10 mW/cm². By this light irradiation, a gas of ClO₂ radicals generated by the reaction of hydrochloric acid and NaClO₂ in the petri dish 3 and flowed into the petri dish 4 was activated, and reacted with the graphene 6. By this surface-treating, a surface of the graphene 6 was oxidized. The graphene 6 after oxidation was dried under reduced pressure for 24 hours to obtain a target object (a substance with a modified graphene 6 surface).

In the present example, as the graphene 6, a substance obtained by modifying the surface of the graphene 6 was produced using powdered graphene (trade name: "06-0313 ", produced by FUJIFILM Wako Pure Chemical Corporation.).

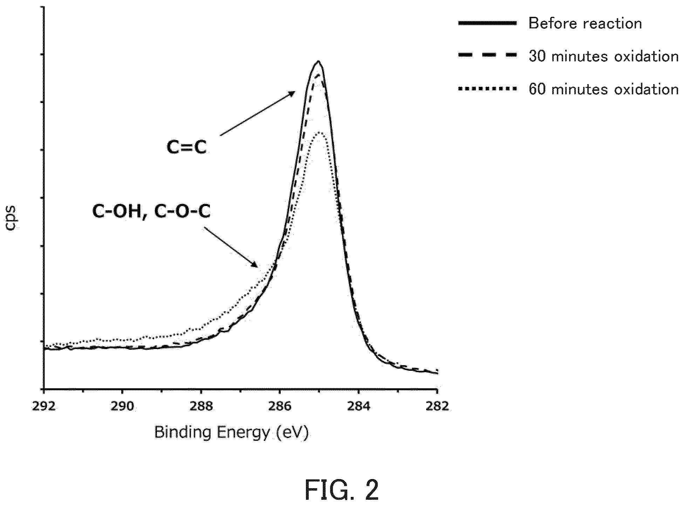

The progress of the oxidation reaction in the graphene 6 was examined by X-ray photoelectron spectroscopy (XPS) measurement before and after the surface-treating (oxidation reaction) to detect the energy-peak position of C1s (1s orbital of carbon atom). The results of the XPS measurement are shown in the graph of FIG. 2. In FIG.2, the horizontal axis indicates the binding energy (eV) and the vertical axis indicates the relative value of the peak intensity (cps).

As described above, FIG. 2 shows the XPS measurement results before and after the surface-treating (oxidation reaction) of graphene. As shown in FIG. 2, there was no major change in 30 minutes after the reaction, but decrease in the C=C bond peak, and increase in the C-OH bond peak and C-O-C bond peak were observed in 60 minutes after the reaction, whereby oxidation of the graphene surface was verified. Further, elemental analysis results by the XPS are summarized in Table 1 below. As summarized in Table 1, the ratio of the number of O atoms was increased after the oxidation reaction, which also verifies the oxidation of the graphene surface.

**Table 1**

| Element ratio of graphene | | |
|---|---|---|
| | O | C |
| Before reaction | 5.4 | 94.6 |
| 30 min after oxidation reaction | 8.3 | 91.6 |
| 60 min after oxidation reaction | 11.4 | 87.8 |

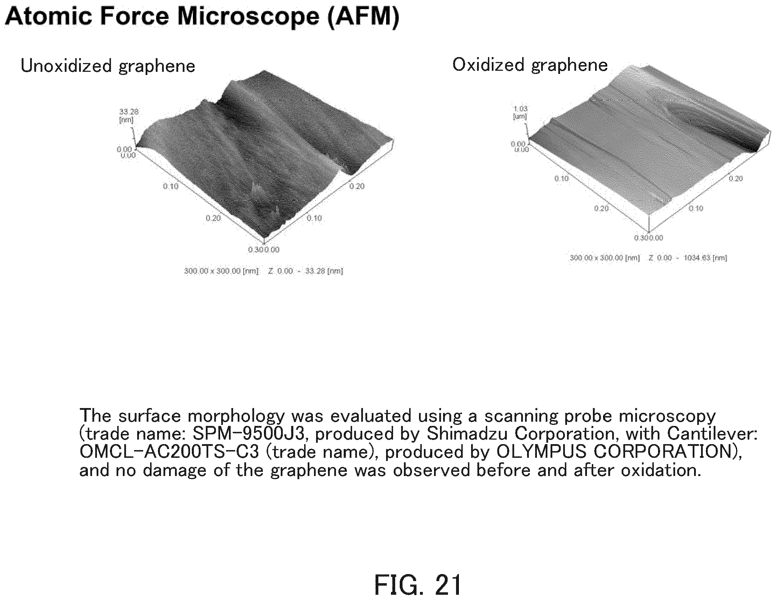

In addition, the state of each graphene surface before and after the surface-treating (oxidation reaction) was observed by AFM (atomic force microscopy). Specifically, the surface morphology was evaluated using a scanning probe microscopy (trade name: SPM-9500J3, produced by Shimadzu Corporation, with Cantilever: OMCL-AC200TS-C3 (trade name), produced by OLYMPUS CORPORATION). The results are shown in FIG. 21. As shown in FIG. 21, according to the evaluation by AFM, no damage or the like of the graphene by the surface-treating (oxidation reaction) was observed, and no deterioration of the graphene was observed.

Further, it is presumed that, for example, the structure of the graphene surface after oxidation in the present reference example is as shown by the following chemical formula E1. However, this structure is only an example of a presumable structure.

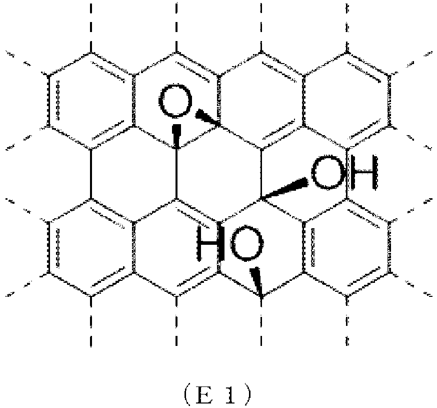

### Reference Example 2

Rhodamine B was bonded to the graphene of Reference Example 1 in the following manner, and the fluorescence intensity was measured.

First, 6 mg of Rhodamine B was added to a test tube. Next, 2 mL of deionized water was added thereto, and then a 0.1 M acetic acid aqueous solution was added to have the pH of 6.5. Two of these were prepared, and the graphene before the oxidation reaction and graphene after 60 minutes of the oxidation reaction were added thereto, respectively, and stirred at room temperature for 15 minutes. After each reaction, the resultant was washed twice using 3 mL of deionized water and dried under reduced pressure for 24 hours. Thereafter, the fluorescence intensity of each resultant was measured using a UV-vis spectrometer with the exciting light at 555 nm in the range from 560 to 660 nm.

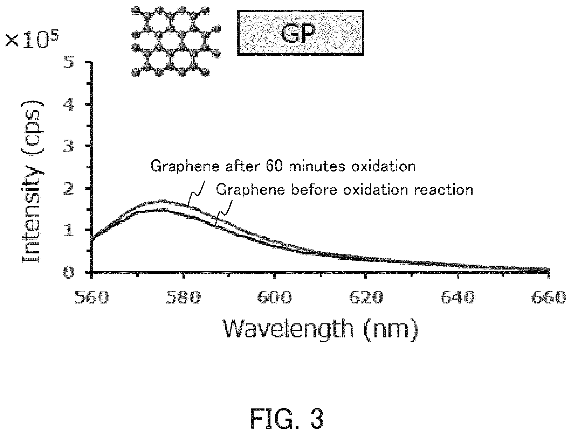

FIG. 3 shows the results of fluorescence intensity measurement of the graphene. In FIG. 3, the horizontal axis indicates the wavelength (nm) and the vertical axis indicates the peak intensity (relative value). As shown in FIG. 3, the peak intensity at around 575 nm of graphene was increased after the oxidation reaction, which verified that rhodamine B was bonded thereto. From this fact, it was inferred that a hydroxy group or a carboxy group or both of them have been introduced into the surface of the graphene after the oxidation reaction.

### Example 1

A graphene grid was produced, and the surface of the produced graphene grid was modified (oxidized) by performing the surface-treating with a chlorine dioxide radical. Then, the functional group-introducing was conducted by introducing a functional group into the modified (oxidized) graphene grid surface to produce a graphene grid into which a functional group was introduced. In addition, a protein, which is a structural analysis target substance to be analyzed by cryo-electron microscopy, was conjugated (bonded) to the graphene grid into which the functional group was introduced.

### [Production of Graphene Grid]

A sheet composed of three layers of polymethyl methacrylate (PMMA)-graphene-Cu was allowed to float such that the Cu surface was brought into contact with the water surface of a 0.5 mol/L ammonium persulfate aqueous solution, and the Cu layer was dissolved by standing still for 30 minutes. The PMMA-graphene sheet thus obtained by removing the Cu layer was allowed to float and washed in an ultrapure water for a total of two times for 10 minutes. Thereafter, a Mo grid (produced by Quantifoil Micro Tools GmbH, trade name: QUANTIFOIL) and an Au grid (produced by Quantifoil Micro Tools GmbH, trade name: QUANTIFOIL) for TEM were placed at the bottom of a film tensioner (produced by Okenshoji Co., Ltd., trade name: Collision film tensioner) filled with ultrapure water. Further, by floating the PMMA-graphene sheet on the water surface of the film tensioner and gently draining the water, the PMMA-graphene sheet was adhered to the grid. The grid was dried for 1 hour at room temperature, and heat treatment was performed for 20 minutes at 130 °C. Thereafter, the grid was immersed in acetone at 60 °C for 60 minutes, chloroform at room temperature (about 25 °C) for 30 minutes, acetic acid for 3 hours, and isopropyl alcohol for 10 minutes in a total of twice to remove PMMA. Finally, heat treatment was performed at 100°C for 10 minutes to produce a graphene grid with a Mo grid or Au grid surface coated with graphene.

### [Reaction between Graphene Grid and Chlorine Dioxide Radical (Surface-Treating)]

Each of the graphene grids produced from the Mo grid and Au grid was subjected to heat treatment at 130°C for 15 minutes. After the heat treatment, the graphene grid was subjected to the surface-treating (surface oxidation) by a chlorine dioxide radical (ClO₂ radical) in the same manner as described in Reference Example 1 and FIG. 1. In the present embodiment, however, the graphene grid was covered with aluminum foil and the surface-treating (surface oxidation) was performed so that the LED light (UV light) did not directly hit the graphene grid. The reaction time (light irradiation time) was set to 10 minutes, and the reaction temperature was set to room temperature as in Example 1. The XPS measurement was performed on the graphene grids before and after the surface-treating in the same manner as in Example 1. As a result, the decrease in the C=C bond peak, the increase in the C-OH bond peak, and the increase in the C-O-C bond peak were observed after the surface-treating, and further, the ratio of the number of O atoms was increased, which verified the oxidation of the graphene surface.

### [Functional Group-Introducing]

A functional group was introduced into the graphene grid surface after the surface-treating (functional group-introducing) according to Scheme 1 below.

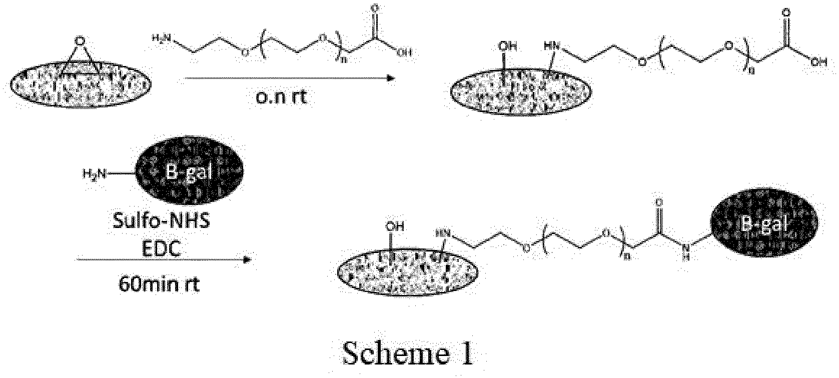

Specifically, the functional group-introducing was performed as follows. First, the graphene grid after the surface-treating was immersed in 2 mmol/L polyethylene glycol 2-aminoethyletheracetic acid and poly(ethylene glycol) 2-aminoethyl ether acetic acid (average molecular weight: 2100) in a DMSO solution, and was allowed to stand overnight at room temperature. Thus, as shown in Scheme 1, a functional group was introduced by reacting an epoxide on the graphene grid surface with the polyethylene glycol 2-aminoethylether acetic acid.

Further, a protein, which is a structural analysis target substance to be analyzed by cryo-electron microscopy, was conjugated (bonded) to the graphene grid subjected to the functional group-introducing. Specifically, the graphene grid was immersed in an aqueous solution containing 5 mmol/L N-hydroxysulfosuccinimide (Sulfo-NHS) and 5 mmol/L EDC for 15 minutes, followed by immersion in an aqueous solution containing 0.2 mg/mL β-galactosidase (B-gal) for 60 minutes to bond by reacting with an amino group present in β-galactosidase (B-gal) as shown in Scheme 1.

### [Reference Example 3]

As described below, the graphene grid surface was modified by the surface-treating of the present invention to produce a substance with a modified graphene grid surface.

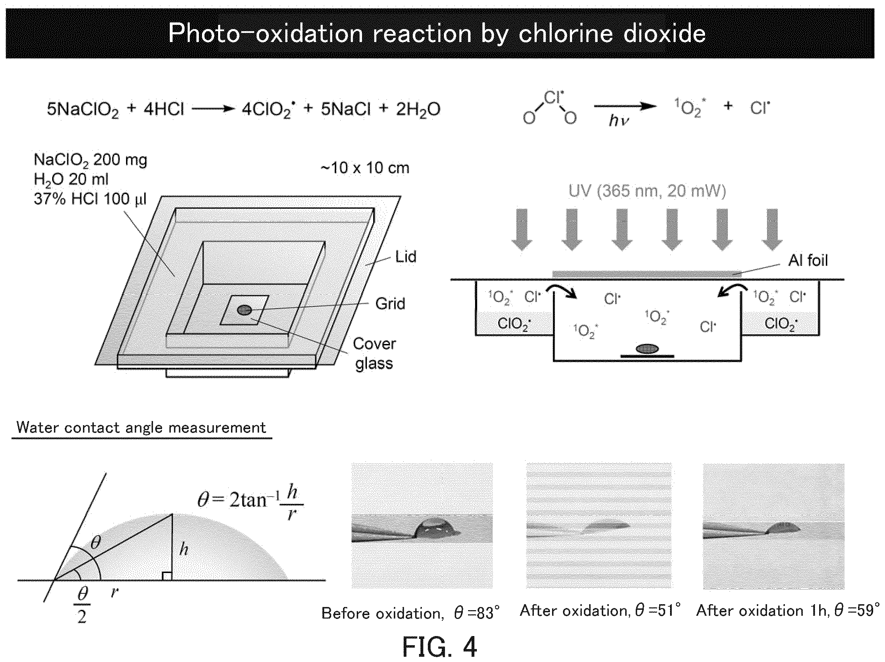

First, sodium chlorite NaClO₂ (200 mg) was dissolved in 20 mL of ultrapure water, and then a 37% by mass HCl aqueous solution (100 µL) was added to prepare a 1% by mass hydrochloric acid NaClO₂ aqueous solution (radical generation reaction system). Subsequently, as shown in FIG. 4, the hydrochloric acid NaClO₂ aqueous solution was added to the outer container of a 10 cm × 10 cm glass-made double walled container (petri dish). Meanwhile, a cover glass was placed in the inner container of the glass double walled container, and a graphene grid produced by the above method was placed on the cover glass. Further, the glass double walled container was covered with a lid to prevent gas inside from leaking. Thereafter, the hydrochloric acid NaClO₂ aqueous solution in the glass double walled container was irradiated with LED light having a wavelength of 365 nm from above the glass double walled container at a light amount of 20 mW/cm² for 10 minutes at room temperature. At this time, as shown in FIG. 4, the upper side of the inner container was covered with an aluminum foil from above the lid so that the graphene grid was not directly exposed to light. By this light irradiation, a ClO₂ radical gas generated by the reaction of hydrochloric acid and NaClO₂ in the petri dish 3 and flowed into the petri dish 4 was activated, and reacted with the graphene 6. By this surface-treating, the graphene grid surface was oxidized. The graphene grid after oxidation was dried under reduced pressure for 24 hours to obtain a target object (a substance with a modified graphene grid surface).

As shown in the lower part of FIG. 4, a water drop was dropped on the graphene grid surface before and after the surface-treating (surface oxidation), the water drop was photographed, and the contact angle of the water was measured by visual inspection of the photograph. As a result, the contact angle of water was 83° before the surface-treating, whereas the contact angle of water was 51° immediately after the surface-treating. In other words, the contact angle of water was reduced by the surface-treating. From this, it was verified that the hydrophilicity of the graphene grid surface was increased. The contact angle of water was measured again by the same method 1 hour after the surface-treating, and was 59° as shown in FIG. 4. That is, it was verified that the hydrophilicity of the graphene grid surface was maintained even 1 hour after the surface-treating.

### Example 2

A graphene grid was produced, and the thus produced graphene grid was subjected to the surface-treating to react its graphene grid with a chlorine dioxide radical to modify (oxidize) the surface, thereby producing a graphene grid with a modified (oxidized) surface. Further, the functional group-introducing was conducted by introducing a functional group into the modified (oxidized) graphene grid surface to produce a graphene grid into which a functional group was introduced. In addition, a protein, which is a structural analysis target substance to be analyzed by cryo-electron microscopy, was conjugated (bonded) to the graphene grid into which the functional group was introduced.

### [Production of Graphene Grid]

A graphene grid with an Au grid surface coated with graphene was produced in exactly the same manner as the " Production of Graphene Grid " described in Example 1.

### [Reaction between Graphene Grid and Chlorine Dioxide Radical (Surface-Treating)]

The graphene grid produced from the Au grid was subjected to the surface-treating (surface oxidization) in exactly the same manner as the "Reaction between Graphene Grid and Chlorine Dioxide Radical (Surface-Treating)" described in Example 1. On the other hand, when XPS measurement was performed in the same manner as in Example 1, the decrease in the C=C bond peak, and the increase of the C-OH bond peak and the increase in C-O-C bond peak were observed after the surface-treating, and further, the ratio of the number of O atoms was increased, which verified the oxidation of the graphene surface.

### Functional Group-Introducing

The graphene grid surface after the surface-treating was reacted with epichlorohydrin to introduce a functional group (functional group-introducing). Specifically, first, the graphene grid after the surface-treating was fixed with tweezers, and 1% by volume of an epichlorohydrin aqueous solution (3 µL) was placed on the graphene-side surface and allowed to stand at room temperature for 5 minutes. Thereafter, the resultant was washed three times with 5 µL of a HEPES buffer (25 mM HEPES, pH: 8.0, 50 mM NaCl, 2 mM MgClz, 1 mM TCEP), and excess epichlorohydrin was washed away. Thus, a graphene grid being the graphene grid into which a 2,3-epoxypropyl group was introduced was obtained.

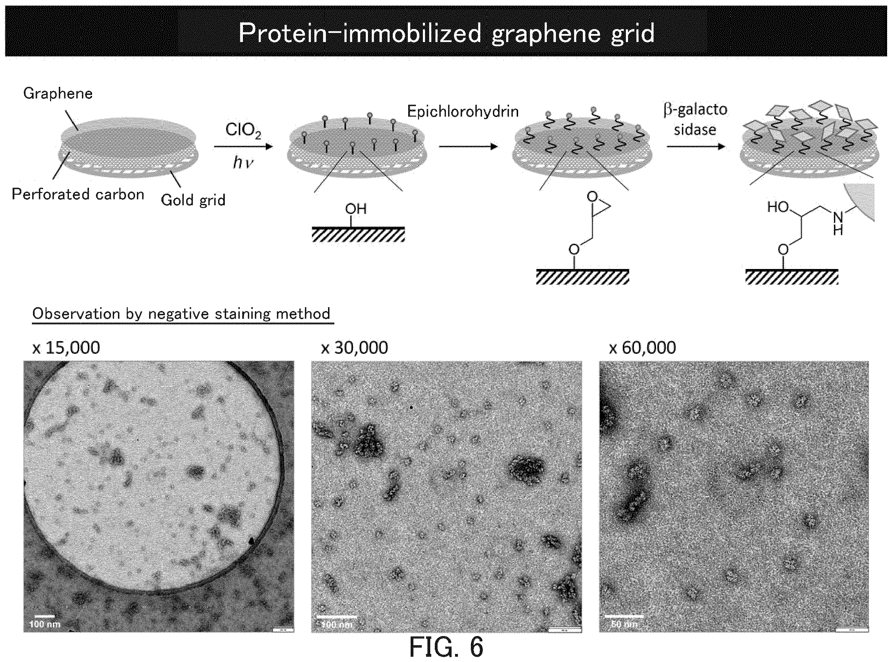

Further, a protein, which is a structural analysis target substance to be analyzed by cryo-electron microscopy, was conjugated (bonded) to the graphene grid subjected to the functional group-introducing. Specifically, the HEPES buffer (3 µL) containing 0.2 mg/mL β-galactosidase (B-gal) was placed on the graphene grid into which the 2,3-epoxypropyl group was introduced and allowed to stand at room temperature for 5 minutes, thereby reacting the 2,3-epoxypropyl group introduced into the graphene grid surface with an amino group present in β-galactosidase (B-gal). Thereafter, the resultant was washed three times with the HEPES buffer (5 µL), and excess β-galactosidase (B-gal) was washed away. While it is presumed that the functional group-introducing and theβ-galactosidase-binding were performed by the reaction according to the scheme in the upper part of FIG. 6, other reactions may have occurred. For example, in the scheme in the upper part of FIG. 6, while the hydroxyl group (OH) on the graphene grid is reacted with epichlorohydrin, a substituent (e.g., a carboxy group) other than the hydroxyl group may react with epichlorohydrin.

The graphene grid surface to which the β-galactosidase was bonded was observed by a negative staining method using a 2% uranyl acetate aqueous solution at magnifications of 15,000×, 30,000×, and 60,000×, respectively, and it was observed that β-galactosidase was bonded to the graphene grid surface as shown in a photograph of the lower part of FIG. 6.

### Example 3

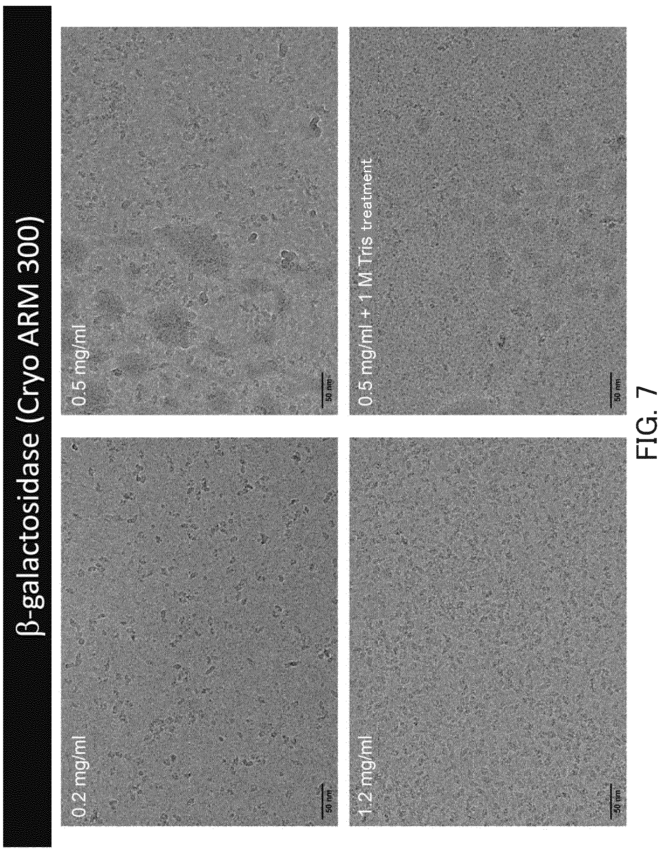

In the same manner as in Example 2, a grid for electron microscopy (usable as a grid for cryo-electron microscopy) having a graphene grid surface to which β-galactosidase was bonded was produced. Then, a grid for electron microscopy having a graphene grid surface to which β-galactosidase was bonded was produced in the same manner as in Example 2, except that the concentration of the β-galactosidase aqueous solution was changed to 0.5 mg/mL or 1.2 mg/mL from of 0.2 mg/mL, or the concentration of the β-galactosidase aqueous solution was changed to 0.5 mg/mL from 0.2 mg/mL and further subjected to 1 M Tris treatment. The 1 M Tris treatment was carried out in order to react a large excess of Tris having an amino group with the 2,3-epoxypropyl group on the graphene grid, and then block the reaction of β-galactosidase with the amino group, by placing 1M tris-hydroxymethylaminomethane ((Tris) pH: 8.0 aqueous solution (3 µL)) on the graphene grid into which the 2,3-epoxypropyl group was introduced and allowing to stand for 5 minutes at room temperature, and then washing three times with the HEPES buffer (5 µL), after the functional group-introducing with epichlorohydrin. Further, the grids for electron microscopy to which the respective β-galactosidases were bonded produced in this manner were rapidly frozen using liquid ethane, and observed with cryo-electron microscopy (trade name: Cryo ARM 300, produced by JEOL Ltd.) at 50,000× magnification. As a result, as shown in FIG. 7, it was observed that the β-galactosidase was bonded only to the graphene grid surface which was not subjected to 1M Tris treatment.

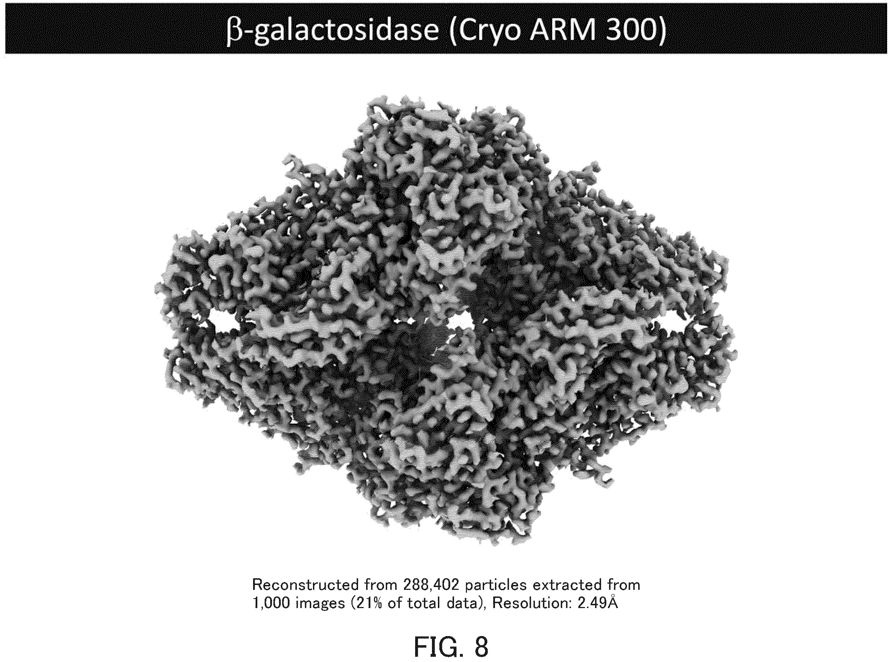

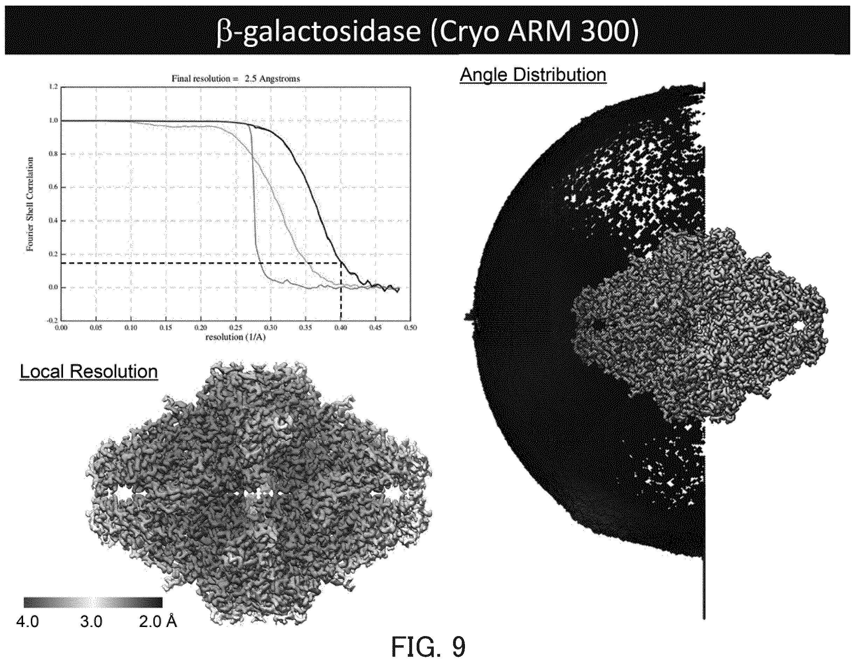

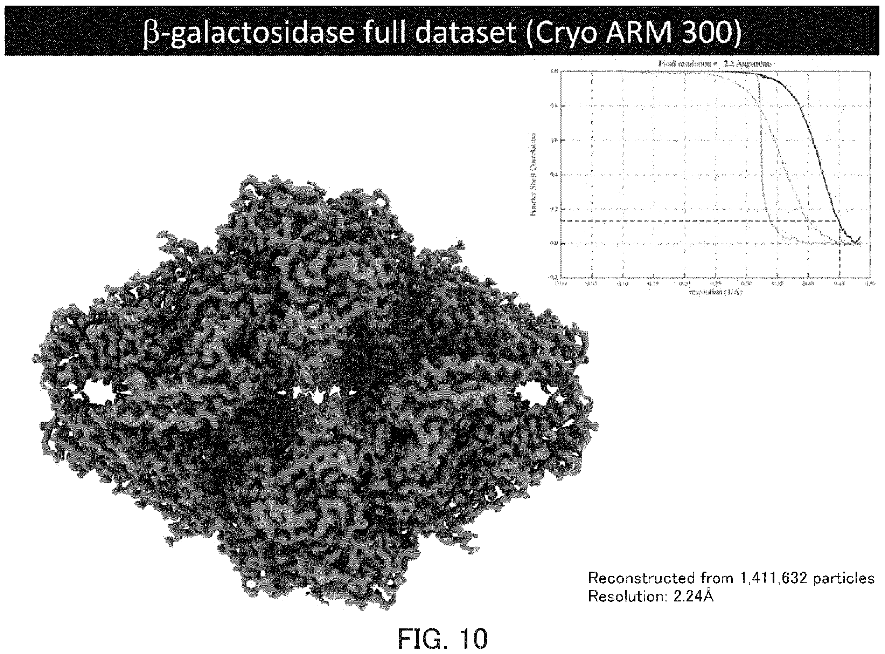

Further, using the grid for electron microscopy with the graphene grid surface to which β-galactosidase was bonded produced as described above, the image data was collected by cryo-electron microscopy (trade name: Cryo ARM 300, produced by JEOL Ltd.), and the structural analysis of the β-galactosidase bonded to the surface was performed using structural analysis software RELION (trade name) based on the obtained data set. As a result, as shown in FIGs. 8 to 10, the structural analysis of β-galactosidase was successful with high resolution of 2.49 Å for 288,402 particles extracted from 1,000 images, and 2.24 Å for 1,411,632 particles extracted from 4,128 images. Note that 1 Å corresponds to 0.1 nm (10⁻¹⁰m). Furthermore, by optimizing the analysis method, we succeeded in the structural analysis of β-galactosidase with higher resolution of 1.81 Å from 231,395 particles extracted from 3,242 images.

### Example 4

In the same manner as in Example 2, the graphene grid was subjected to the surface-treating (oxidation reaction with chlorine dioxide radical) and the functional group-introducing (introduction of an epoxy group by reaction with epichlorohydrin). Then, 40 µL of 1H,1H-undecafluorohexylamine was added and stirred for 60 minutes to react, thereby obtaining a grid with graphene into which a fluoroalkyl amino group was introduced. The resulting grid was washed twice with deionized water and dried under reduced pressure for 24 hours.

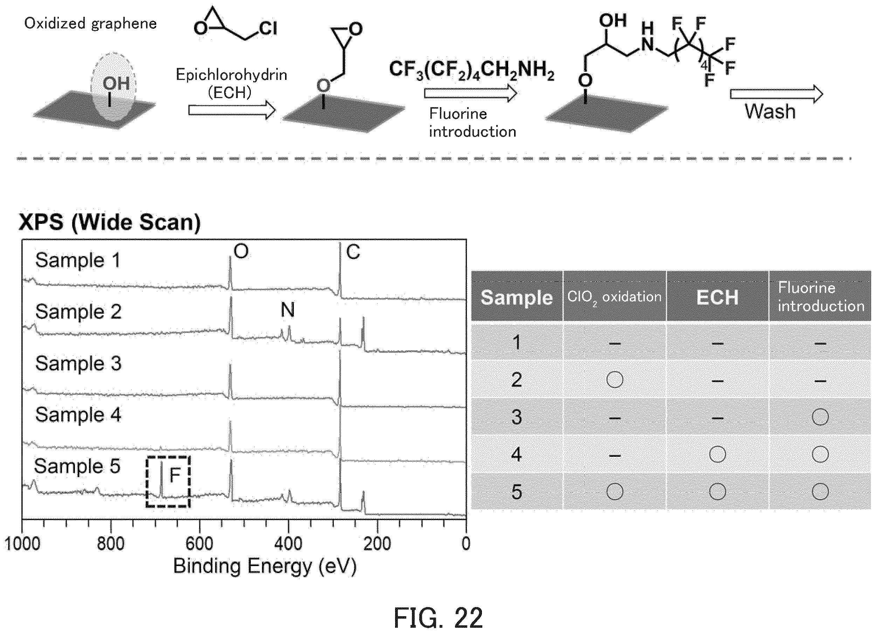

Note that the functional group introduction reaction in the present example is presumed as shown in the scheme on the upper part of FIG. 22. As shown in FIG. 22, it is considered that the hydrogen of the hydroxy group on the nanodiamond surface was substituted with a 2,3-epoxypropyl group, and further, an addition reaction was generated between the epoxy group and 1H,1H-undecafluorohexylamine. In addition, samples reacted with 1H,1H-undecafluorohexylamine were prepared in the same manner except that one or both of the surface-treating (oxidation reaction with chlorine dioxide radical) and the functional group-introducing (introduction of an epoxy group by reaction with epichlorohydrin) were not performed, and XPS was measured together with the grid of the present example. The measurement results of XPS are shown in the graph and table in the lower part of FIG. 22. As shown in FIG. 22, only the grid (Sample 5) of the present example in which both the surface-treating (oxidation reaction with chlorine dioxide radical) and the functional group-introducing (introduction of an epoxy group by reaction with epichlorohydrin) were performed showed the presence of fluorine atoms on the surface. From this, it was verified that the reaction with 1H,1H-undecafluorohexylamine (bond to the grid surface) occurred.

### Example 5

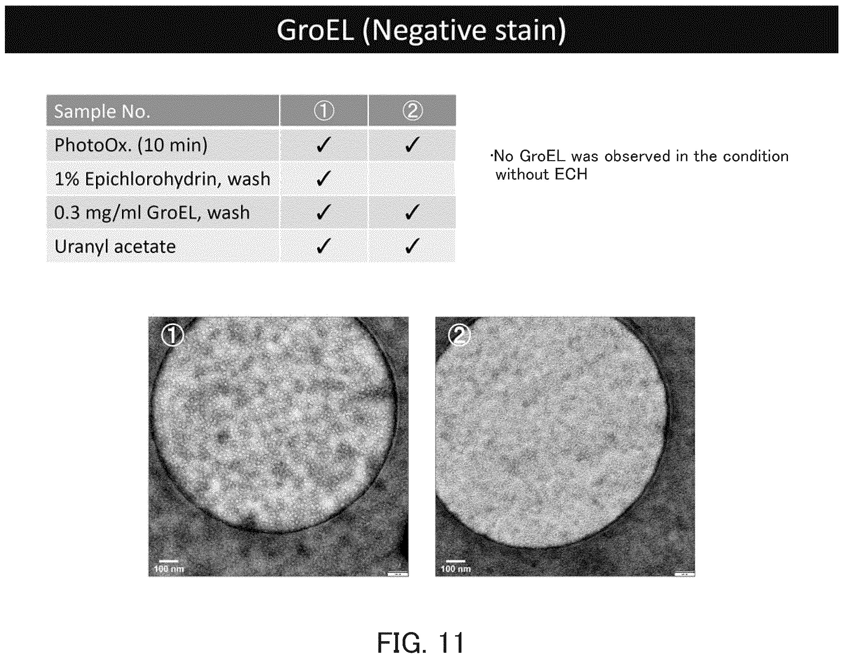

A grid for electron microscopy (usable as a grid for cryo-electron microscopy) having a graphene grid surface to which GroEL was bonded was produced in the same manner as in Example 2, except that a sheet composed of four layers (polymethyl methacrylate (PMMA)-graphene-Cu-graphene) was used to remove graphene that was not on the PMMA side using water-resistant abrasive paper (P3000), and that in removing PMMA, the resultant was immersed in acetic acid twice for 2 hours each and then immersed in isopropyl alcohol for 10 minutes without performing treatment with acetone and chloroform, and that a HEPES buffer (25 mM HEPES, pH: 8.0, 50 mM NaCl) containing 0.3mg/mL GroEL was used instead of the buffer containing β-galactosidase. Note that GroEL is a kind of chaperonin protein, and is a protein to be analyzed by cryo-electron microscopy. Further, another grid for electron microscopy was produced in the same manner, except that the treatment with an epichlorohydrin aqueous solution (introduction of an epoxy group as a functional group) was not performed. The surfaces of these two grids for electron microscopy were observed by a negative staining method using a 2% uranyl acetate aqueous solution. The results are shown in the photographs of FIG. 11. As shown in FIG. 11, in the grid (1) for electron microscopy having been treated with an epichlorohydrin aqueous solution (introduction of an epoxy group as a functional group), GroEL bonded to the surface was observed . In contrast, no GroEL was observed in the grid (2) that has not been subjected to the treatment with an epichlorohydrin aqueous solution (introduction of an epoxy-group as a functional group).

### Example 6

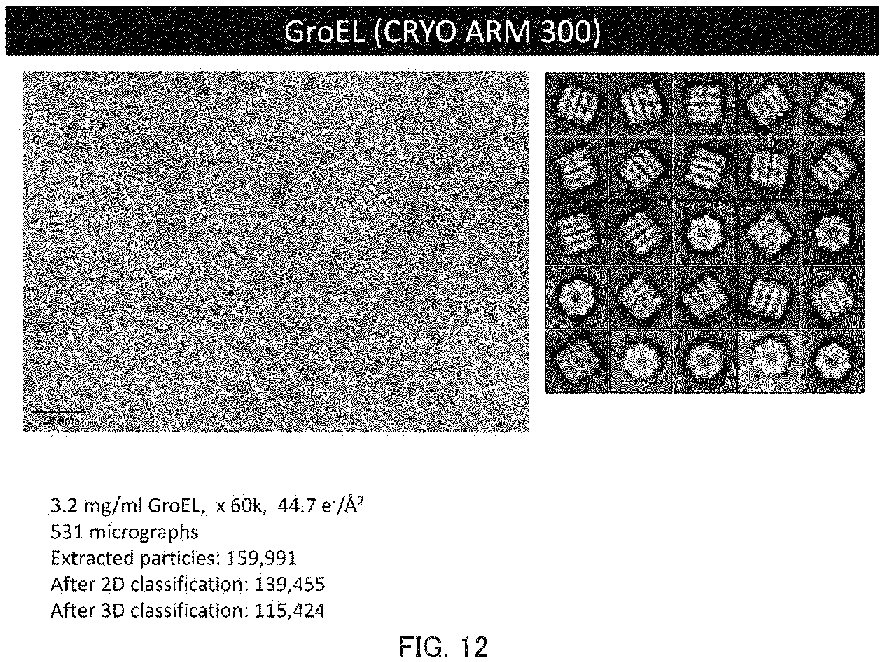

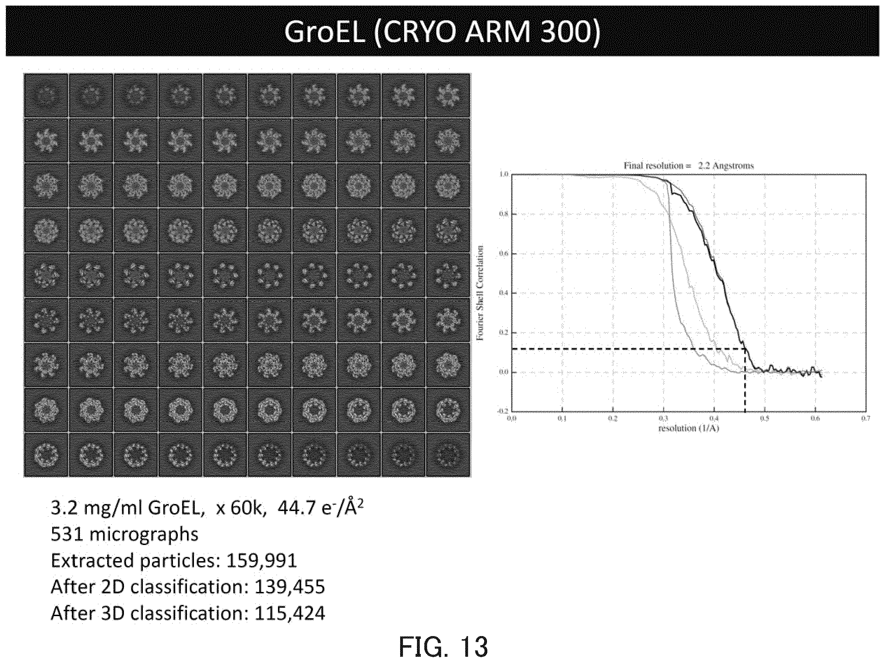

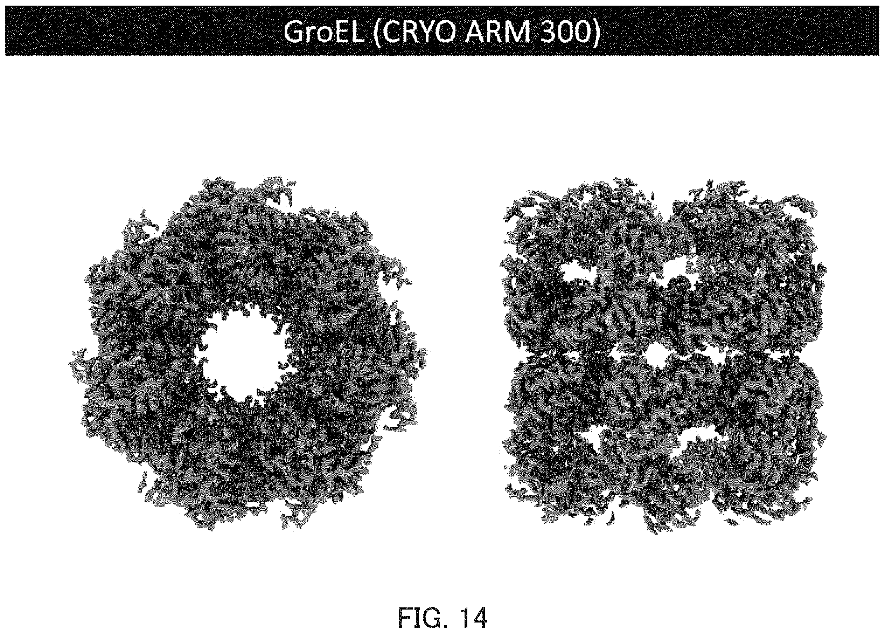

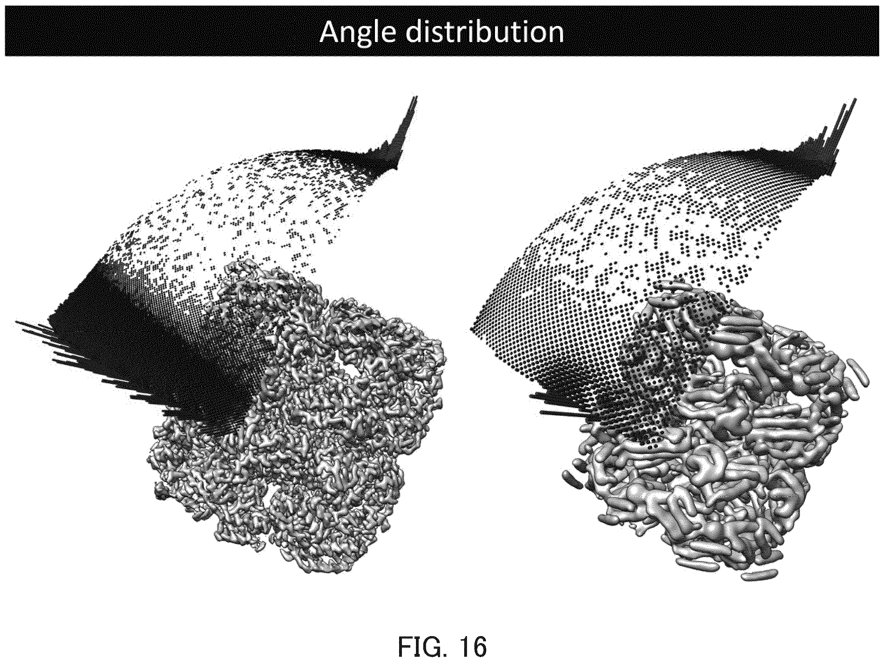

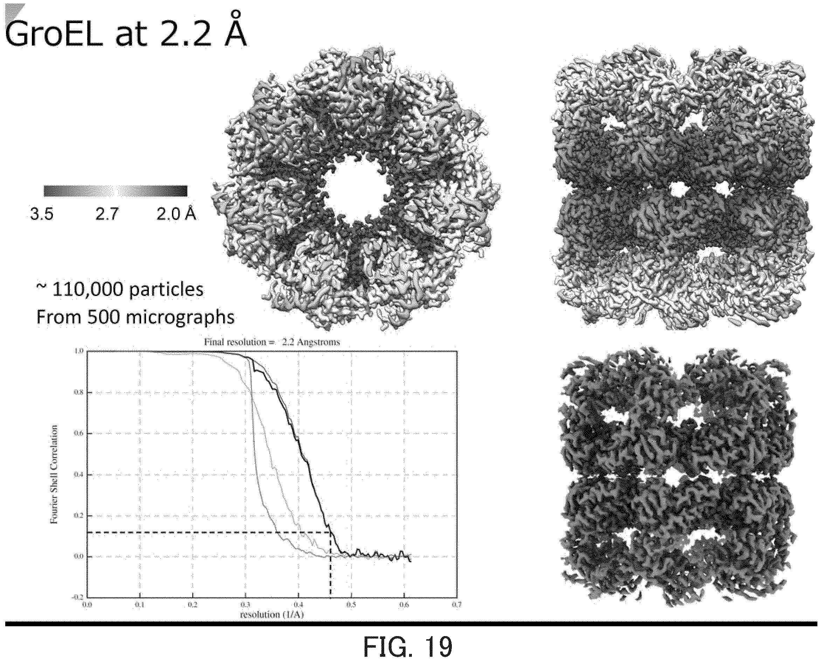

A grid for electron microscopy (usable as a grid for cryo-electron microscopy) having a graphene grid surface to which GroEL was bonded was produced in the same manner as in Example 2, except that a HEPES buffer (25 mM HEPES, pH 8.0, 50 mM NaCl) containing 3.2 mg/mL GroEL was used instead of the buffer containing β-galactosidase. Further, using this grid for electron microscopy with the graphene grid surface to which GroEL was bonded, the image data was collected by a cryo-electron microscopy (trade name: Cryo ARM 300, produced by JEOL Ltd.), and the structural analysis of GroEL bonded to the surface was performed using structural analysis software RELION (trade name) based on the obtained data set. As a result, as shown in FIGs. 12 to 16 and 19, the structural analysis of GroEL was successfully conducted with very high resolution of 2.18 Å from 115,424 particles extracted from 531 images. As of August 2020, the highest resolution of GroEL map registered in The Electron Microscopy Data Bank (EM Data Bank) was 3.26 Å, and the present example resulted in a significant update of this data. The major factor is that, as shown in the distribution diagram of the projection angle of the molecules in FIG. 16, the proportion in the lateral direction is greatly increased, and uneven orientation in the vertical direction (the direction along the seven-fold axis), which was a problem in the analysis by a conventional method, was eliminated. In addition, by optimizing the analysis method, the structural analysis of GroEL was successful at even higher resolution of 1.99 Å from 158,485 particles extracted from 504 images.

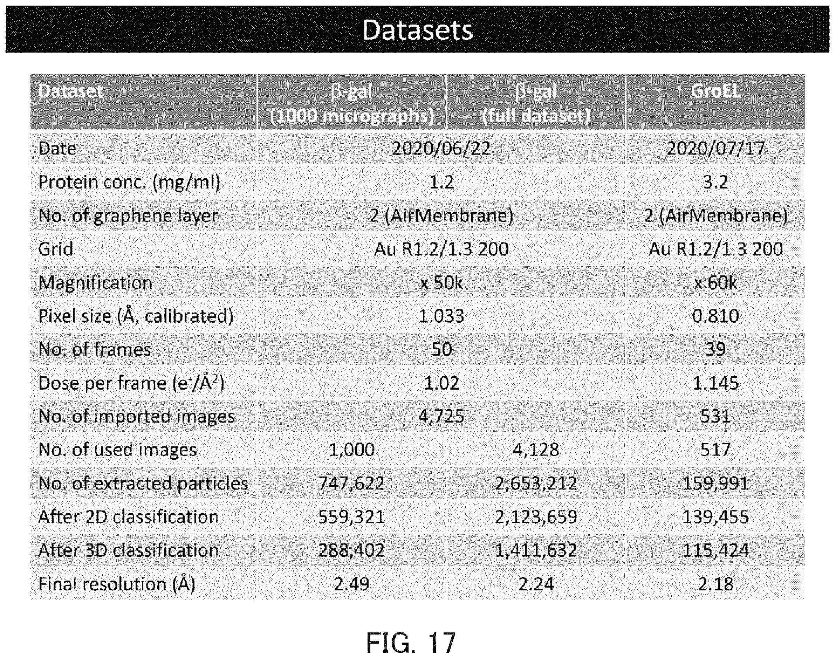

The results of the structural analysis of β-galactosidase or GroEL conducted using a cryo-electron microscopy (trade name: Cryo ARM 300, produced by JEOL Ltd.) in Examples 3 and 6 are summarized in the table in FIG. 17.

### [Example 7]

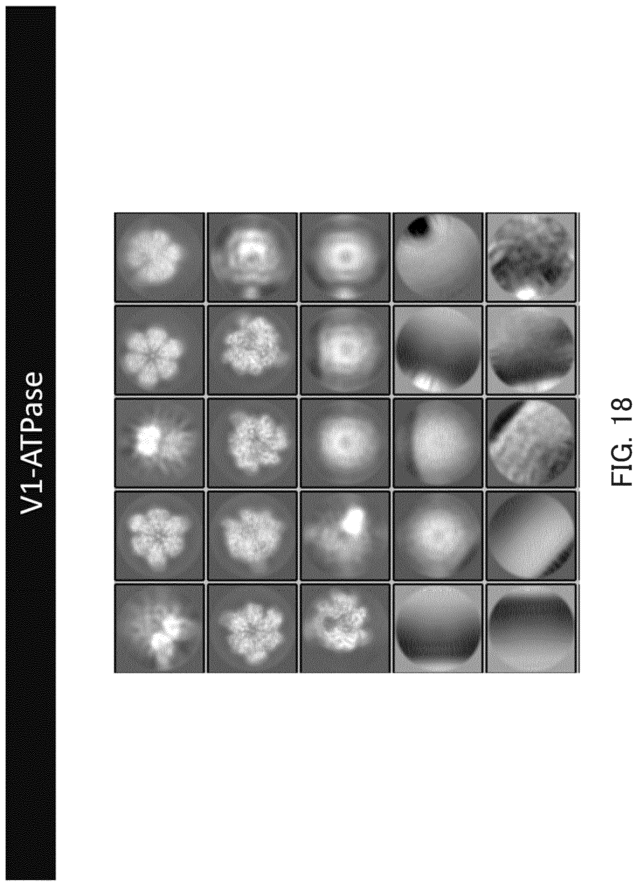

A grid for electron microscopy (usable as a grid for cryo-electron microscopy) having a graphene grid surface to which V1-ATPase was bonded was produced in the same manner as in Example 2, except that a 1.0 mg/mL V1-ATPase aqueous solution was used instead of the buffer containing β-galactosidase. Note that V1-ATPase is a kind of enzyme, and is a protein to be analyzed by cryo-electron microscopy. Further, using this grid for electron microscopy with the graphene grid surface to which V1-ATPase was bonded, the image data was collected by acryoelectron microscopy (trade name: Cryo ARM 300, produced by JEOL Ltd.), and the structural analysis of V1-ATPase bonded to the surface was performed using structural analysis software RELION (trade name) based on the obtained data set. As a result, as shown in FIGs. 18 and 20, the structural analysis of V1-ATPase was successful with very high resolution of about 2.6 Å from about 300,000 particles extracted.

### Example 8

In the same manner as in Example 2, the graphene grid was subjected to the surface-treating (oxidation reaction with chlorine dioxide radical) and the functional group-introducing (introduction of an epoxy group by reaction with epichlorohydrin). In this manner, a graphene grid (upper left in Scheme 2 below) into which a functional group (epoxy group) was introduced was produced. Thereafter, a graphene grid (upper right in Scheme 2 below) into which a maleimide group was introduced was further obtained according to Scheme 2 below. Further, a protein (β-galactosidase), which is a structural analysis target substance to be analyzed by cryo-electron microscopy, was conjugated (bonded) to the obtained graphene grid according to the lower scheme in Scheme 2 below.

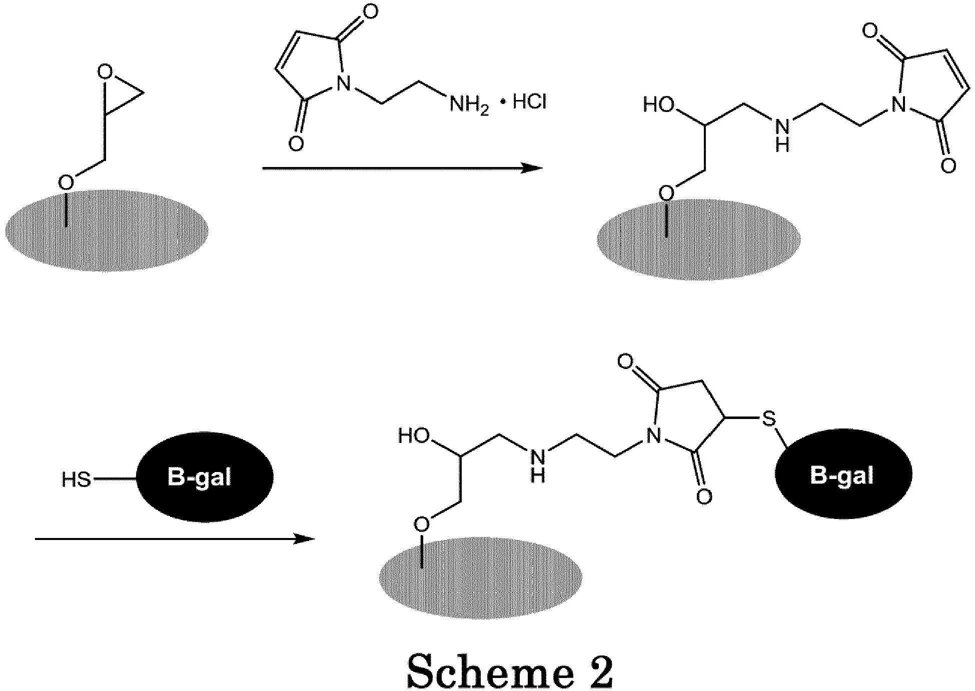

Specifically, the reaction of Scheme 2 was carried out as follows. First, as described above, in the same manner as in Example 2, the graphene grid was subjected to the surface-treating (oxidation reaction with chlorine dioxide radical) and the functional group-introducing (introduction of an epoxy group by reaction with epichlorohydrin) to produce a graphene grid into which a functional group (epoxy group) was introduced (upper left in Scheme 2). Next, a 56 mM N-(2-aminoethyl)maleimide hydrochloride (in the middle of the upper part of Scheme 2) aqueous solution (pH: 9.0, 3 µL) was placed on the graphene grid into which the functional group (epoxy group) was introduced and allowed to stand at room temperature for 5 minutes, and then washed three times with distilled water (5 µL) to wash off excess N-(2-aminoethyl)maleimide hydrochloride. In this manner, the 2,3-epoxypropyl group introduced into the graphene grid surface was reacted with the amino group present in the N-(2-aminoethyl)maleimide hydrochloride, thereby obtaining a graphene grid into which the maleimide group was introduced (upper right in Scheme 2).

Further, a protein (β-galactosidase), which is a structural analysis target substance to be analyzed by cryo-electron microscopy, was conjugated (bonded) to the graphene grid into which the maleimide group was introduced. Specifically, a Tris buffer (25 mM Tris, pH: 7.0, 50 mM NaCl, 2 mM MgClz, 1 mM dithiothreitol (DTT)) containing 0.5 mg/mL β-galactosidase (B-gal) was placed on the graphene grid into which the maleimide group was introduced and allowed to stand at room temperature for 5 minutes, whereby the maleimide group introduced into the graphene grid surface was reacted with a sulfhydryl group present in β-galactosidase (B-gal) to bond. Thereafter, the resultant was washed three times with the Tris buffer (5 µL), and excess β-galactosidase (B-gal) was washed away. In this manner, a graphene grid to which β-galactosidase was bonded (lower right of Scheme 2 above) was obtained.

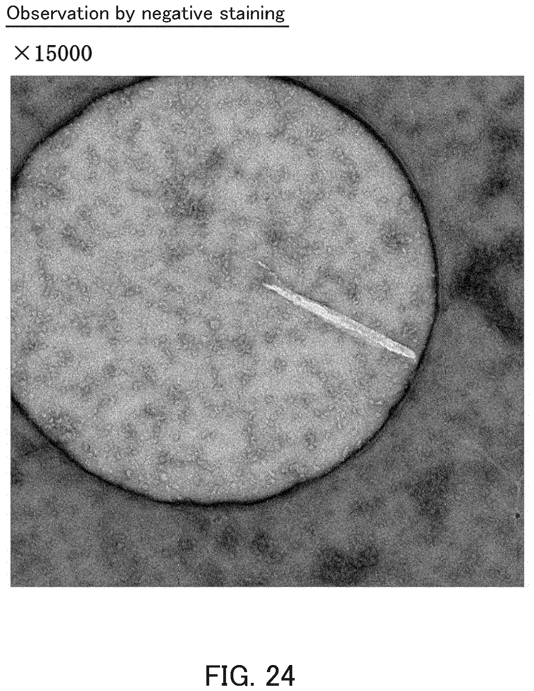

The graphene grid surface to which the β-galactosidase was bonded was observed at 15,000× magnification by a negative staining method using a 2% uranyl acetate aqueous solution. As shown in the photograph of FIG. 24, it was observed that the β-galactosidase was bonded to the graphene grid surface.

### Example 9

In the same manner as in Example 2, the graphene grid was subjected to the surface-treating (oxidation reaction with chlorine dioxide radical) and the functional group-introducing (introduction of an epoxy group by reaction with epichlorohydrin). In this manner, a graphene grid (upper left in Scheme 3 below) into which a functional group (epoxy group) was introduced was produced. As shown in Scheme 3 below, the graphene grid was further reacted with NH₂-PEG4-NH₂ and then reacted with epichlorohydrin, and further conjugated (bonded) with a protein (GroEL), which is a structural analysis target substance to be analyzed by cryo-electron microscopy.

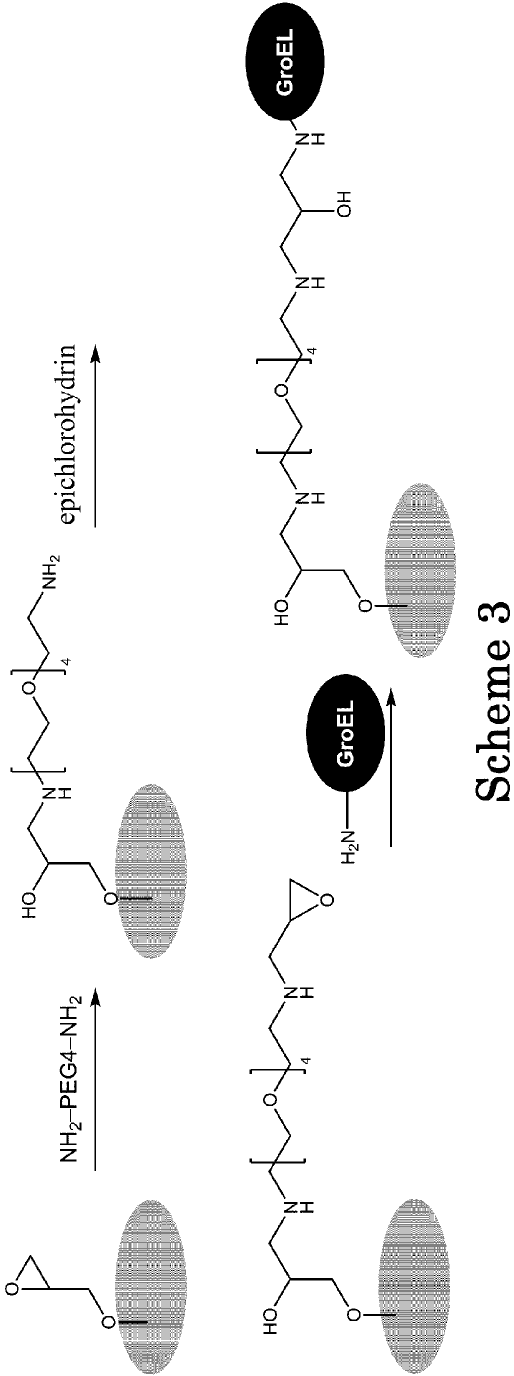

Specifically, the reaction of Scheme 3 was carried out as follows. First, as described above, in the same manner as in Example 2, the graphene grid was subjected to the surface-treating (oxidation reaction with chlorine dioxide radical) and the functional group-introducing (introduction of an epoxy group by reaction with epichlorohydrin) to produce a graphene grid into which a functional group (epoxy group) was introduced (upper left in Scheme 3). Next, a 42 mM NH₂-PEG4-NH₂ aqueous solution (3 µL) was placed on the graphene grid into which the functional group (epoxy-group) was introduced, and the grid was allowed to stand at room temperature for 5 minutes, and then washed three times with distilled water (5 µL) to wash off excess NH₂-PEG4-NH₂. Thereby, the 2,3-epoxypropyl group introduced into the graphene grid surface was reacted with an amino group present in NH₂-PEG4-NH₂, Accordingly, a graphene grid to which the 2,3-epoxypropyl group was bonded was obtained. In addition, 1% by volume of an epichlorohydrin aqueous solution (3 µL) was placed on the graphene-side surface and allowed to stand at room temperature for 5 minutes, and then washed three times with distilled water (5 µL) to wash off excess epichlorohydrin. In this manner, the amino group introduced into the graphene grid surface was reacted with an epoxy group present in the epichlorohydrin, thereby obtaining a graphene grid into which the 2,3-epoxypropyl group and PEG chain were introduced (lower left of Scheme 3).

Further, a protein, which is a structural analysis target substance to be analyzed by cryo-electron microscopy, was conjugated (bonded) to the graphene grid having been subjected to the functional group-introducing. Specifically, a HEPES buffer (25 mM HEPES, pH: 8.0, 50 mM NaCl) containing 0.3 mg/mL GroEL was placed on the graphene grid into which the 2,3-epoxypropyl group and PEG chain were introduced, and the grid was allowed to stand at room temperature for 5 minutes, whereby the epoxy group introduced into the graphene grid surface was reacted with an amino group present in GroEL to bond. Thereafter, the resultant was washed three times with the HEPES buffer (5 µL), and excess GroEL was washed away. In this manner, a graphene grid to which a protein (GroEL), which is a structural analysis target substance to be analyzed by cryo-electron microscopy, was bonded (lower right of Scheme 3) was obtained.

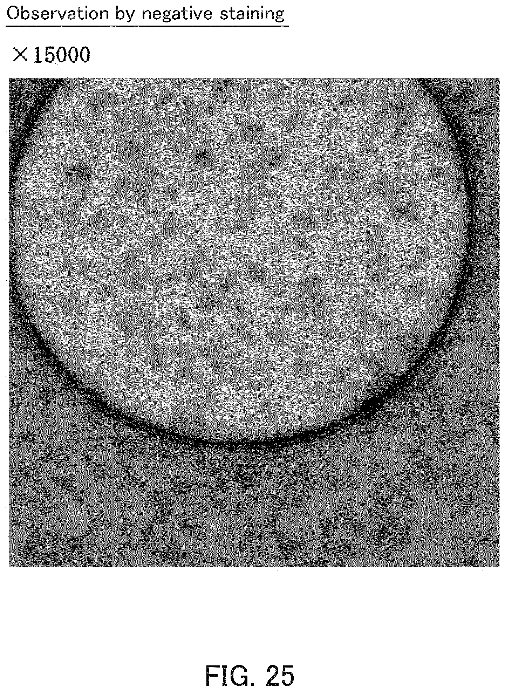

Further, the graphene grid surface to which the GroEL was bonded was observed at 15,000× magnification by a negative staining method using a 2% uranyl acetate aqueous solution. As shown in the photograph of the lower part of FIG. 25, it was observed that the GroEL was bonded to the graphene grid surface.

### Example 10

The graphene grid with the modified (oxidized) surface was produced by conducting surface-treating by reacting the single-layer graphene (graphene grid) on the copper substrate with a chlorine dioxide radical to modify (oxidize) the surface in exactly the same manner as the "Reaction between Graphene Grid and Chlorine Dioxide Radical (Surface-Treating)" described in Example 1, except that a single-layer graphene (ACS Materials: trade name "CVCU1S22") on a copper substrate was used instead of the graphene grid produced from the Au grid of Example 1. Further, according to Scheme 4 below, the functional group-introducing was conducted by introducing a new functional group into the hydroxyl group of the modified (oxidized) graphene surface in the gas phase. Accordingly, a graphene grid into which the functional group was introduced (functional group-introducing) is produced.

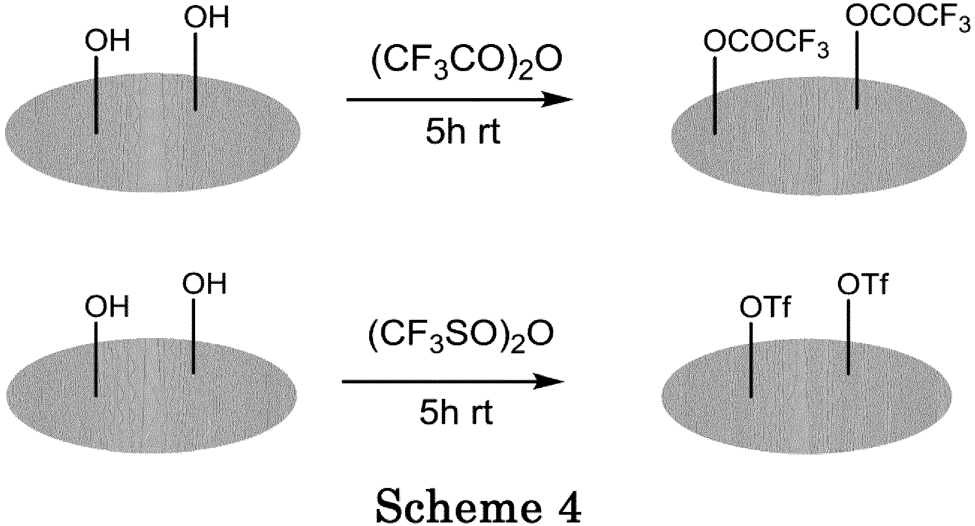

### [Reaction of Graphene with Trifluoroacetic Anhydride after Surface-Treating]

Specifically, the reaction shown in the upper part of Scheme 4 was carried out as follows. First, a cover glass was placed in a 6 cm × 6 cm glass-made petri dish, and the graphene (graphene grid) on the copper substrate after the surface-treating was placed thereon. Further, a 3 cm × 3 cm glass-made petri dish containing trifluoroacetic anhydride (molecular weight: 282, 2 mL) was placed inside the aforementioned glass petri dish, and the dish was covered with a lid and allowed to stand at room temperature for 5 hours. Thus, as shown in the upper part of Scheme 4, the hydroxy group on the graphene surface was reacted with the trifluoroacetic anhydride to introduce a trifluoroacetyl group. Thereby, a graphene grid into which a trifluoroacetyl group was introduced as a functional group was produced (functional group-introducing).

### [Reaction of Graphene with Trifluoromethanesulfonic Anhydride after Surface-Treating]

Specifically, the reaction shown in the lower part of Scheme 4 was carried out as follows. First, a cover glass was placed in a 6 cm × 6 cm glass-made petri dish, and the graphene (graphene grid) on the copper substrate after the surface-treating was placed thereon. Further, a 3 cm × 3 cm glass-made petri dish containing trifluoromethanesulfonic anhydride (molecular weight: 282, 2 mL) was placed inside the aforementioned glass petri dish, and the dish was covered with a lid and allowed to stand at room temperature for 5 hours. Thus, as shown in the lower part of Scheme 4, the hydroxy group on the graphene surface was reacted with the trifluoromethanesulfonic anhydride to introduce a trifluoromethylsulfonyl group. Thereby, a graphene grid into which a trifluoromethylsulfonyl group was introduced as a functional group was produced (functional group-introducing).

The graphene on the copper substrate was subjected to X-ray photoelectron spectroscopy (XPS) measurement before and after the surface-treating (oxidation reaction), after the reaction with trifluoroacetic anhydride, and after the reaction with trifluoromethanesulfonic anhydride, thereby conducting the elemental analysis. The results of the elemental analysis by XPS are summarized in Table 2 below. As summarized in Table 2 below, the ratio of the number of F atoms increases after the reaction with trifluoroacetic anhydride, and the ratio of the number of F atoms and the number of S atoms increases after the reaction with trifluoromethanesulfonic anhydride. This showed the functionalization of the graphene surface.

**Table 2**

| Element ratio of graphene | | | | |
|---|---|---|---|---|
| | O | C | F | S |
| Before reaction | 21.0 | 79.0 | - | - |
| After oxidation | 56.5 | 43.5 | - | - |
| Reaction with trifluoroacetic anhydride | 31.6 | 35.6 | 32.8 | - |
| Reaction with trifluoromethanesulfonic anhydride | 27.9 | 65.8 | 3.9 | 2.4 |

As demonstrated by Examples, according to the present invention, a measurement sample for cryo-electron microscopy can be easily prepared in a very short time. Furthermore, as demonstrated by Examples, the structural analysis of various proteins such as β-galactosidase, GroEL, and V1-ATPase can be performed with extremely high accuracy and high resolution without tagging.

While the present invention has been described above with reference to illustrative embodiments, the present invention is by no means limited thereto. Various changes and variations that may become apparent to those skilled in the art may be made in the configuration and specifics of the present invention without departing from the scope of the present invention.

### Industrial Applicability

As described above, according to the present invention, it is possible to provide a grid for cryo-electron microscopy, a method for producing a grid for cryo-electron microscopy, and a method for analyzing a structural analysis target substance, which can suppress or prevent uneven distribution, uneven orientation, and the like of a structural analysis target substance, in a structural analysis by cryo-electron microscopy. According to the present invention, for example, a grid for cryo-electron microscopy in which a structural analysis target substance such as a protein is bonded can be produced in a very short time, and the structural analysis of the structural analysis target substance can be performed with extremely high resolution, so that its industrial use value is great.

### Reference Signs List

- 1:: petri dish
- 2:: lid
- 3:: petri dish
- 4:: petri dish
- 5:: radical generation reaction system
- 6:: carbon allotrope
- 11:: organic layer (organic phase)
- 12:: aqueous layer (aqueous phase)

## Claims

1. A graphene grid having a graphene surface into which a functional group is introduced.

2. The graphene grid according to claim 1, having a graphene surface into which at least one substituent selected from the group consisting of a hydroxy group, a carboxy group, and an aldehyde group is introduced, and the functional group is introduced by a reaction of the substituent.

3. The graphene grid according to claim 1 or 2, wherein
the functional group is at least one group selected from the group consisting of a hydroxy group, a carboxy group, an aldehyde group, a carbonyl group, an ether bond, an ester bond, an amino group, an imino group, a sulfonyl group, a sulfonyloxy group, and a fluoroalkyl group.

4. The graphene grid according to claim 1 or 2, wherein
the functional group is an ether bond.

5. The graphene grid according to claim 1 or 2, wherein
the functional group is an epoxy group.

6. A grid for cryo-electron microscopy being the graphene grid according to any one of claims 1 to 5 to which a structural analysis target substance to be analyzed by cryo-electron microscopy is bonded.

7. A method for producing a graphene grid formed of a substance having a graphene surface into which a functional group is introduced, comprising steps of:
treating a surface by reacting a graphene surface with a halogen oxide radical so as to modify the graphene surface; and
introducing the functional group into a modified graphene surface.

8. The method according to claim 7, wherein
in the introducing the functional group, at least one functional group selected from the group consisting of a hydroxy group, a carboxy group, an aldehyde group, a carbonyl group, an ether bond, an ester bond, an amino group, an imino group, a sulfonyl group, a sulfonyloxy group, and a fluoroalkyl group is introduced as the functional group.

9. The method according to claim 7, wherein
in the introducing a functional group, an ether bond is introduced as the functional group.

10. The method according to claim 7, wherein
in the introducing a functional group, an epoxy group is introduced as the functional group.

11. The method according to any one of claims 7 to 10, wherein
the halogen oxide radical is a chlorine dioxide radical.

12. A method for producing a grid for cryo-electron microscopy, comprising a step of:
binding a structural analysis target substance to be analyzed by cryo-electron microscopy to the graphene grid produced by the method according to any one of claims 7 to 11.

13. A method for analyzing a structural analysis target substance using cryo-electron microscopy, comprising steps of:
preparing a grid for structural analysis; and
analyzing a structural analysis target substance, wherein
in the preparing a grid for structural analysis, the structural analysis target substance is bonded to the graphene grid according to any one of claims 1 to 5 or the graphene grid produced by the method according to any one of claims 7 to 11, or the grid for cryo-electron microscopy according to claim 6 or the grid for cryo-electron microscopy produced by the method according to claim 12 is prepared, and
in the analyzing a structural analysis target substance, the structural analysis target substance bonded to the graphene grid is analyzed by cryo-electron microscopy.

14. The method according to claim 13, wherein
the structural analysis target substance is an organic substance.

15. The method according to claim 14, wherein
the organic substance is a protein.
